# EUROPEAN PATENT APPLICATION

(11) **EP 4 819 770 A1**
(43) Date of publication of application: **07.10.2026**
(21) Application number: 26167766.0
(22) Date of filing: 25.03.2026
(51) Int. Cl.: H05K 1/11, H05K 3/40, H05K 3/341, H05K 1/14

(54) **COMPONENT CARRIER WITH EMBEDDED VERTICAL CONNECTION, AND MANUFACTURE METHOD**

(30) Priority: 31.03.2025 CN 202510399602
(71) Applicant: AT&S Austria Technologie & Systemtechnik Aktiengesellschaft, 8700 Leoben (AT)
(72) Inventor: WANG, Raymond, Chongqing, 401331 (CN); WU, Light, 32845 Taoyuan City (TW); CHIU, Michael, 235 New Taipei City (TW); PU, Lindsey, Chongqing, 400071 (CN); ZENG, Tiki, Zhoujiawan Village, 413400 (CN)
(74) Representative: Dilg, Haeusler, Schindelmann Patentanwaltsgesellschaft mbH

(57) **Abstract**

There is provided a component carrier and method for manufacturing the same. The component carrier comprises a stack having a plurality of electrically insulating layer structures and at least one electrically conductive layer structure, and at least one electrically vertical connection encapsulated by a first dielectric material of a first electrically insulating layer structure of the plurality of electrically insulating layer structures, wherein the at least one electrically vertical connection comprises at least one pad and at least one pillar vertically connected to each other.

## Description

### Field of the Invention

The present invention relates to a component carrier, and a method of manufacturing a component carrier.

### Technical Background

In the context of growing product functionalities, component carriers are now equipped with one or more electronic components. Simultaneously, miniaturization continues to advance, along with a rising number of components to be mounted on or embedded in the component carriers like printed circuit boards. As a result, a fine-pitch, high-density interconnect (HDI) structure is required to integrate more components within a smaller space.

As known in the art, a typical interconnect structure, such as a general embedded trace substrate (ETS) structure, is used with via and conductive trace formation to establish an electrical connection between a component carrier and other components (or a further component carrier). However, a general ETS structure that employs stacked vias, particularly those with a tapered shape resulting from laser drilling, can typically accommodate only a single embedded fine-pitch layer.

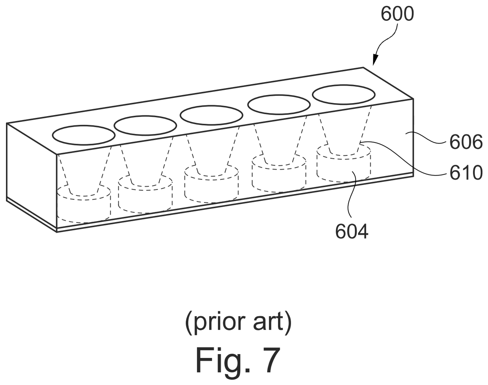

**Figure 7** illustrates one example of a conventional component carrier 600 with a general ETS structure where conductive traces 604 are electrically connected in a vertical direction (which may also refer to a stacking direction) through vias 610 embedded within at least one dielectric layer 606. Normally, the conductive traces 604, together with vias 610, are embedded within the at least one dielectric layer 606. Said dielectric layer 606 along with the conductive trace 604 is configured as an ETS (embedded trace substrate) layer structure that is formed by a top or outer layer of the conventional component carrier 600 to facilitate providing electrical interfaces between components (and/or a further component carrier) mounted thereto. As used herein, vias 610 typically refer to microvias obtained by a laser drilling process, subsequently filled (or plated) with a conductive material, preferably with copper. As illustrated in Figure 7, vias 610 are provided substantially perpendicular to a main lateral extension of the conventional component carrier 600 and each electrically interconnects at least one conductive trace 604 provided on or embedded in the at least one dielectric layer 606 to form interconnections through the at least one dielectric layer 606. In the example shown in Figure 7, a fine via interconnection, e.g., with a fine Line/Space (L/S), can be obtained through a modified semi-additive process (mSAP) technology. However, the vias 610, such as laser-drilled microvias, typically feature tapered sidewalls with varying opening or outer diameters at the top, allowing for better wall metallization. For instance, the lateral dimension (which particularly refers to the opening or outer diameter) of the vias 610 is generally in the range of 45 to 120 µm. Due to the tapering profile from a cross-section view, the larger dimension (opening or outer diameter) of the vias 610 may be less than 120 µm, and the smaller dimension (opening or outer diameter) of the vias 610 may be more than 45 µm. Such variety of lateral dimension may result in only a single ETS layer formed within the conventional component carrier 600.

On the other hand, the varied lateral dimension may further cause weak mechanical strength to the conventional component carrier 600, and brings disadvantages to the HDI applications which require dense electronic connection (e.g., ultra-fine L/S), especially at the lateral direction. Moreover, the via interconnections may limit a modularization of the conventional component carrier 600, for example the available space for routing may be restricted with a high-density via placement, thereby resulting in a less design flexibility and scalability in the HDI applications.

Regarding those drawbacks, a properly (or well-) designed interconnect structure with a uniform geometric shape (particularly an isotropic vertical extension with a constant cross section) is necessary to ensure a reliable and efficient connection between conductive traces within one or more dielectric layers.

### Summary of the Invention

There may be a need to provide a component carrier with an efficient and reliable interconnect structure.

A component carrier and a method of manufacturing a component carrier according to the exemplary embodiments of the invention are provided. According to an exemplary embodiment of the invention, a component carrier is provided, which comprises:
i) a stack having a plurality of electrically insulating layer structures and a plurality of electrically conductive layer structures;
ii) at least one electrically vertical connection encapsulated by a dielectric material of a first electrically insulating layer structure of the plurality of electrically insulating layer structures of the stack,

wherein the at least one electrically vertical connection comprises at least one pad and at least one pillar (vertically) connected to each other, and wherein the at least one pad is exposed at a first main surface of the first electrically insulating layer structure and the at least one pillar is exposed at a (opposing) second main surface of the first electrically insulating layer structure; iii) wherein the exposed surface of the at least one pad and/or the exposed surface of the at least one pillar comprises a connection structure configured to be connected to at least one of the plurality of electrically conductive layer structures, and
wherein the dielectric material exposed at the respective main surface of the first electrically insulating layer structure where the connection structure is exposed, is in direct contact with a second electrically insulating layer structure of the plurality of electrically insulating layer structures.

According to another exemplary embodiment of the invention, a method of manufacturing a component carrier is provided, wherein the method comprises:
i) forming a stack comprising a plurality of electrically insulating layer structures and a plurality of electrically conductive layer structures,
ii) encapsulating at least one electrically vertical connection by a dielectric material of a first electrically insulating layer structure of the plurality of electrically insulating layer structures of the stack,

wherein the at least one electrically vertical connection comprises at least one pad and at least one pillar (vertically) connected to each other,
wherein the at least one pad is exposed at a first main surface of the first electrically insulating layer structure and the at least one pillar is exposed at a (opposing) second main surface of the first electrically insulating layer structure; iii) wherein the exposed surface of the at least one pad and/or the exposed surface of the at least one pillar comprises a connection structure configured to be connected to at least one of the plurality of electrically conductive layer structures, and
wherein the dielectric material exposed at the respective main surface of the first electrically insulating layer structure where the connection structure is exposed, is in direct contact with a second electrically insulating layer structure of the plurality of electrically insulating layer structures.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board (PCB), an organic interposer, and an integrated circuit (IC) substrate. A component carrier may also be a hybrid board combining different ones of the above-mentioned types of component carriers.

In the context of the present document, the term "stack" may particularly denote a flat or planar sheet-like body. For instance, the stack may be a layer stack, in particular a laminated layer stack or a laminate. Such a laminate may be formed by connecting a plurality of layer structures by the application of mechanical pressure and/or heat. In addition, a stacked body may include a first (top) main surface and a second (bottom) main surface that are opposed to each other in a stacking direction. The stacking direction (also particularly referring to a thickness direction of the stack) is substantially perpendicular to a main lateral extension of the stacked body.

In the context of the present document, the term "layer structure" may particularly denote one of a continuous layer, a patterned layer and an arrangement of multiple connected and/or non-connected islands within one common plane. For instance, such a layer structure may be a continuous foil or sheet, whereas such a foil or sheet may also be patterned.

In the context of the present document, the term "electrically vertical connection" may particularly refer to an electrically conductive structure that extends in the vertical direction through a component carrier stack. In particular, the electrically vertical connection may be configured to electrically connect two conductive entities, such as an electronic component and a conductive layer structure, trace, or pad. In comparison to prior art stacked vias (see Figure 7 above), the electrically vertical connection may be free from a tapered-shaped feature. In the present invention, the electrically vertical connection is encapsulated by dielectric material, that can also be recognizable in the final product by the flow lines of the dielectric material (also recognizable by the fillers distribution/direction) and sometime by the rounded shape of this dielectric provided on the sharped corners filled by resin. Preferably, the electrically vertical connection may comprise a uniform geometric profile, such as a straight sidewall, preferable a (copper) pillar or pad. More preferably, the uniform geometric structure, like copper pillar, may have a constant diameter (width) less than 60 µm, in particular less than 30 µm. This uniform design can facilitate an efficient and reliable interconnect structure within a component carrier, in particular due to the fact that having the pillar a constant cross section, a higher diameter interacting with the (planar) surface pad is provided. In some examples, the electrically vertical connection may be made of a homogeneous material, in particular plated metal, preferable plated copper. In this regard, a (signal) integrity and/or stability of an interconnect structure can be enhanced within a component carrier. Alternatively, the electrically vertical connection may be made of a heterogeneous material, e.g., comprising two or more distinct conductive materials. Despite the material differences, this configuration can still ensure an efficient, robust, and reliable interconnect structure within a component carrier.

In the context of the present document, the term "connected" may particularly denote a (direct or indirect) connection that an element can be directly connected with another element. In the present invention, the at least one pad and the at least one pillar may be structurally and electrically (e.g., directly) connected to each other, without any intermediary elements in between. Alternatively, the at least one pad and the at least one pillar may be electrically connected to each other, with one or more intermediary elements in between. According to a preferred embodiment of the present invention, the at least one pad and the at least one pillar are structurally and electrically (e.g., directly) connected to each other along a planar connecting surface; alternatively, the at least one pillar are structurally and electrically (e.g., directly) connected to each other along a rounded connecting surface.

In the context of the present document, the term "in direct contact with a second electrically insulating layer structure" may particularly denote a face-to-face contact between two electrically insulating layer structures contacting each other without any intermediary elements in between. Such a direct contact may also establish a direct physical (or structural) connection between the electrically insulating layer structures. Correspondingly connected electrically insulating layer structures may not be separated from each other without applying high force and/or thermal energy or without damage. In the present invention, a direct contact between the first electrically insulating layer structure and the second electrically insulating layer structure may create an intermingling region at the contact area. In an embodiment, such an intermingling region may be formed by semi-curing of the resin after heating. This direct contact may contribute to the modularization of the component carrier, due to the direct dielectric material interactivity with a second electrically insulating layer structure as claimed.

In the context of the present document, the term "exposed surface" may particularly denote a (contact) surface area that is exposed with respect to a carrier dielectric and is accessible at a main surface of a component carrier layer for further manufacturing process, for example electric connection purposes. The exposed (contact) surface may comprise or consist of a connection structure (as described below). For example, the exposed surface of a carrier contact may be located on the same level, in the stack direction, as an exposed carrier dielectric. In other words, the exposed (contact) surface and the exposed dielectric surface may be flush. Alternatively, the exposed (contact) surface may extend below or above the exposed dielectric surface in the stack direction. By way of example, a recessed space or a bump may be formed on the exposed (contact) surface with respect to the exposed carrier dielectric. In an embodiment, the exposed surface may become unexposed as it will be covered by other layers in the subsequent process.

In the context of the present document, the term "connection structure" may particularly refer to an electrically conductive contact element or structure that is accessible at an interface of two connected entities for electric connection purposes. In the present invention, the connection structure may particularly refer to a structure or feature formed onto an exposed surface of the at least one pad and/or of the at least one pillar and being configured to establish a reliable and stable electrical connection at the interface (between the at least one electrically vertical connection and the at least one electrically conductive layer structure). Preferably, such a connection structure may comprise or consist of two or more distinct conductive materials in the form of stacked layer structures, e.g., a tin layer sandwiched between two nickel layers, to ensure an efficient and reliable electrical connection.

According to an exemplary embodiment of the invention, a component carrier is provided in which an electrically vertical connection is created to facilitate an efficient and reliable interconnect structure. For this purpose, not only a fine vertical interconnect structure comprising at least one pad and at least one pillar may be established, but also a reliable connection may be established through forming a connection structure on an exposed surface of the at least one pad and/or of the at least one pillar.

For instance, the at least one pad and the at least one pillar, both typically having a uniform (or isotropic) vertical extension, are stacked vertically and continuously extend through one of a plurality of electrically insulating layer structures of a component carrier layer stack. In this regard, the at least one pad can provide a horizontal conductive surface (e.g. as part of a conductive trace/pattern) that offers a mechanical strength and/or facilitates signal distribution. The at least one pillar can serve as a vertical conductive or thermal pathway that interconnects the adjacent pad(s). In this regard, a plurality of electrically vertical connections can be closely accommodated within a first electrically insulating layer structure and efficiently (also easily) encapsulated by a dielectric material of the first electrically insulating layer structure. Hence, this configuration can enable a finer interconnect structure within a component carrier (when compared to conventional via interconnections).

In addition, when compared to conventional laser-drilled microvias, the at least one pillar typically has a constant cross section (diameter or width) less than 60 µm, in particular less than 30 µm. Such a uniform profile can facilitate an efficient and reliable electrically vertical connection. Moreover, the connection structure may be (structurally and electrically) connected to the exposed at least one pad (and/or to the exposed at least one pillar) and at least one electrically conductive layer structure of an adjacent (or separate) layer. In this regard, the connection structure may facilitate an electrical communication between the electrically vertical connection and an external component (or element). For instance, the connection structure may comprise or consist of a conductive material, which may be preferably different across the structure. Hence, this configuration can further ensure an efficient and reliable electrically vertical connection.

More specifically, the connection structure may comprise or consist of a diffusion layer, which may help in managing (particularly preventing) material interdiffusion during lamination. For example, the diffusion layer may serve as a (preferable thin) diffusion barrier at the connected interface, which can (effectively) prevent an (undesired) atomic diffusion of copper atoms through the interface and reduce potential oxidation or contamination during lamination. In addition to that, the diffusion layer may be or include a (very thin) growth of an intermetallic compound (preferably including nickel and/or tin) at the interface. The presence of the intermetallic compound(s) can enhance a mechanical strength and thermal stability of the connection structure, while also improving an electrical conductivity thereof.

Additionally, when the component carrier comprises a plurality of electrically vertical connections (as described above) encapsulated by or embedded within (at least two of) the plurality of electrically insulating layer structures, thus an efficient and reliable multilayer interconnect structure can be achieved.

Moreover, a hybrid (interfacial) bonding (the bonding between insulating materials and the bonding between conductive materials) may also be established, for instance combining a metal bonding (e.g., copper-copper bonding) between the electrically vertical connection (in particular with the connection structure) and the at least one electrically conductive layer structure, along with a direct dielectric bonding (e.g., resin-resin bonding) between two dielectric materials. Such a hybrid bonding approach may not only ensure a reliable connection across different material interfaces but also enable an increased modularization of the component carrier. For instance, a direct dielectric contact between the first electrically insulating layer structure and a second electrically insulating layer structure may be established, through which an association to a further structure of the stack by the connection structure can be modeled in an easy and flexible manner. Hence, an enhanced structural integrity and electrical performance of an interconnect structure can be further achieved within a component carrier with reduced encumbrances and increased modularization.

Furthermore, the plurality of electrically insulating layer structures may comprise or consist of a coreless substrate, such as a coreless layer. This arrangement can contribute to the compactness of a component carrier in a vertical direction. As a result, an efficient and reliable interconnect structure can be achieved within a compact component carrier. In particular, a small size of pillars (high density) may provide an efficient and small (highly dense) bridge functionality.

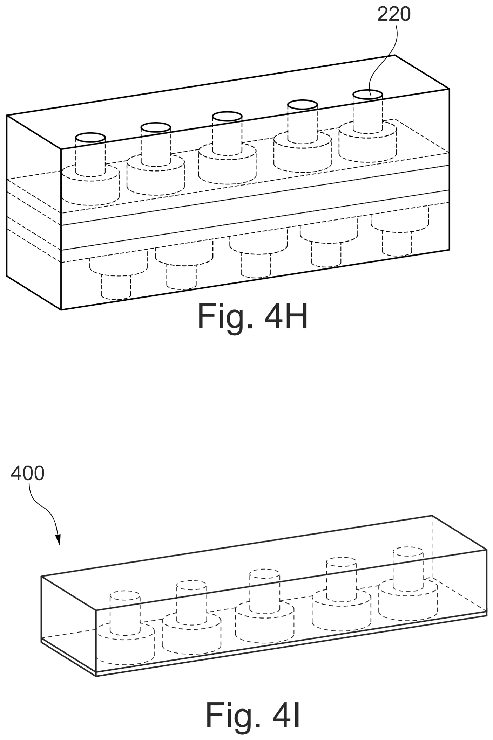

In a preferred embodiment, the described component carrier may provide at least one of the following advantages:
- Fine lines: due to the vertical straight extension of the pad and the pillar, the electrically vertical connections can be closer one to each other and easily (subsequently) encapsulated even though being close to each other.
   - Reliable connections: when the pillar comprises a constant cross section, a higher diameter interacting with the (planar) surface pad can be provided.
- Modularization: due to the possible formation of several modules (compare e.g. Figure 4I), an easy and straightforward association to a further module or to a structure of the stack may be enabled by the connection structure (also due to the circumstance that dielectric material is in direct contact with a second electrically insulating layer structure) (for example using metal direct bonding as described further below).

In the following, further exemplary embodiments of the component carrier and the method will be explained.

In an embodiment, the component carrier further comprises a plurality of electrically vertical connections (embedded) in and/or encapsulated by the first electrically insulating layer structure, wherein the plurality of electrically vertical connections comprises a plurality of pads and a plurality of pillars (vertically) connected to each other. For example, the plurality of electrically vertical connections may be arranged adjacent to each other, in particular oriented in parallel along the vertical direction. Preferably, the plurality of electrically vertical connections may comprise at least one pad array and at least one pillar array that are stacked on top of each other (in the vertical direction) and vertically encapsulated by the first dielectric material. Each of the pad and pillar arrays may not have any limitation imposed on the stacking number. In one embodiment, at least two pad arrays and at least one pillar array may be alternatively stacked one above another (in the vertical direction) and at least partially penetrate through the first electrically insulating layer structure. Preferably, a thickness of the first electrically insulating layer structure may be equal to a total height of one or more pad and pillar arrays along the vertical direction. In this regard, the plurality of electrically vertical connections (particularly an alternating stack of the pad and pillar arrays) may facilitate high-density, three-dimensional interconnections. Advantageously, this configuration may enable an efficient signal routing and enhanced electrical performance of a component carrier.

In an embodiment, the at least one electrically vertical connection, in particular each of the plurality of electrically vertical connections, comprises a vialess electrically conductive layer structure. In the context of the present application, the term "vialess electrically conductive layer structure" may particularly refer to an electrically conductive layer structure that is free from tapered-shaped features, such as those typically formed by standard laser vias. A conventional via structure typically includes tapered, column-like shapes filled with a conductive material to establish vertical connections through one or more dielectric layers. Typically, a standard via structure typically has a diameter size of 45 to 120 µm. In contrast, a vialess electrically conductive layer structure can exhibit a uniform geometric profile, facilitating fine, high-density vertical interconnections among one or more conductive structures. In some embodiments, the vialess electrically conductive layer structure may feature a straight sidewall, preferably formed as a metal pad, a metal pillar, or the like. The uniformity of the vialess structure can facilitate a vertical (and lateral) electrical interconnection without a need for conventional vias, thereby simplifying the fabrication process and improving signal integrity by reducing parasitic capacitance and inductance typically associated with standard laser vias. Additionally (also preferably), the uniform geometric structure, like copper pillar, may have a diameter (width) less than 60 µm, in particular less than 30 µm. Advantageously, this design can enhance the overall structural reliability of a component carrier.

In an embodiment, the at least one or the plurality of the pad and/or pillar has at least one of the following shapes: cylindrical, rectangular, polygonal. Preferably, the at least one or the plurality of the pad and/or pillar may have a uniform, non-tapered shape, and be free from any slanted or angled features. For instance, the at least one or the plurality of the pad and/or pillar is free of a slanted or tapered shape that may degrade an electrical performance or structural reliability. More specifically, the at least one or the plurality of the pad and/or pillar comprises a straight sidewall, e.g., a substantially continuous, vertically straight sidewall. Advantageously, this configuration may facilitate an efficient and robust vertical interconnect structure within a component carrier, while ensuring an enhanced flexibility and structural reliability.

In an embodiment, the at least one or the plurality of the pad and/or the at least one or the plurality of the pillar has a diameter (width) less than 60 µm, in particular less than 30 µm. A standard via structure typically has a diameter size of 45 to 120 µm. In this way, the at least one or the plurality of the pad and/or of the pillar may contribute to a more robust and dense connection when compared to the conventional via structure. In some embodiments, the at least one or the plurality of the pad and/or of the pillar may comprise a different width or a similar width, particularly an identical width across its height. Advantageously, this uniformity or controlled variation in width may allow for tailored electrical and mechanical properties, depending on specific design requirements. Alternatively, even when a different (varied or adapted) width is employed, a design flexibility can be significantly enhanced, such as allowing for optimized routing density, signal integrity, and mechanical strength. Additionally, the at least one or the plurality of the pad and/or of the pillar may preferably have a similar height, particularly an identical height. For instance, the at least one or the plurality of the pad and of the pillar may share identical dimensions (e.g., width and height). However (also preferably), the at least one or the plurality of the pad may have a height different from (e.g., greater or less than) that of the at least one or the plurality of the pillar. Advantageously, this configuration can ensure a reliable and flexible interconnect structure within a component carrier. In an embodiment, the exposed at least one pad and/or the exposed at least one pillar is recessed by a recessed space with respect to the respective main surface of the first electrically insulating layer structure. More specifically, the dielectric material encapsulates circumferential sidewalls and expose an upper surface of the at least one pad at a first main surface of the first electrically insulating layer structure. Additionally or alternatively, the dielectric material may further encapsulate circumferential sidewalls and expose a bottom surface of the at least one pillar at a (opposing) second main surface of the first electrically insulating layer structure. However, the exposed upper surface of the at least one pad and/or the exposed bottom surface of at least one pillar is not flush with, for instance set back or recessed below, the respective main surface of the first electrically insulating layer structure. In this regard, a recessed space is formed around the exposed at least one pad and/or pillar within the first electrically insulating layer structure. Advantageously, this recessed configuration may serve as a protective cavity, shielding the at least one pad and/or pillar from an external surface and/or mechanical force while remaining accessible for a direct electrical connection. Additionally, during a manufacturing process (particularly during a subsequent bonding or stacking process), the recessed space may act as a guide or alignment feature that can improve an alignment accuracy and enhance a connection integrity.

Additionally or alternatively, the recess space can be configured to assure a bonding of the exposed at least one pad and/or the exposed at least one pillar with a further pad or pillar or electrically conductive layer structure due to the expansion of the exposed at least one pad and/or the exposed at least one pillar toward the external side, for example in a bonding step, in particular hybrid bonding step, where an increase of temperature is provided. Hence, this configuration may provide a more reliable and integral bonding (or stacking). In a further embodiment, a diffusion layer is associated to the connection structure, wherein the diffusion layer has a coefficient of thermal expansion (CTE) lower than a CTE of the at least one electrically vertical connection and preferably defines the recessed space. For instance, the CTE of a material in the diffusion layer may vary (gradually), from one side to other side. More specifically, the connection structure comprises a diffusion layer that is recessed within the recessed space. Preferably, the connection structure comprising the diffusion layer may be flush with the respective main surface of the first electrically insulating layer structure. In an embodiment, a (substantially) flat connection surface may be provided between the at least one electrically vertical connection and an external element (e.g., the at least one electrically conductive layer structure), thereby ensuring a reliable electric connection as well as avoidance of cracks. Additionally (or preferably), the diffusion layer within the recess may comprise an anchor-structure (eventually protruding into the respective electrically insulating layer structure), which can further strengthen the stiffness between the at least one electrically vertical connection and the at least one electrically conductive layer structure connected thereto. In an embodiment, a recess of the diffusion layer may protrude into the respective electrically insulating layer. In an embodiment, the diffusion layers may be configured to prevent the migration of metal, in particular copper.

In addition, the diffusion layer may have a coefficient of thermal expansion (CTE) lower than that of the at least one electrically vertical connection. By selecting a diffusion layer material with a comparatively lower CTE, a component carrier can be realized with an enhanced thermal and mechanical reliability of an interconnect structure. Moreover, such CTE mismatch may also allow the diffusion layer to act as a stress buffer that can effectively minimize and redistribute a thermal expansion force away from a critical conductive pathway. Advantageously, this arrangement can ensure a more reliable and efficient interconnect structure within a component carrier.

More specifically, the connection structure may comprise or consist of a (thin) metal layer of nickel and/or tin, such as a nickel layer, a tin layer, a nickel/tin layer, or similar configurations. In this regard, the provision of a nickel layer may serve as an (effective) diffusion barrier, for example preventing an (undesirable) atomic interdiffusion of underlying materials, such as copper atoms, and reducing potential oxidation and contamination during lamination. Hence, this (thin) diffusion barrier can help maintain a structural and electrical integrity of the connection structure over time, thereby enhancing the overall reliability of a component carrier. Additionally (or alternatively), the tin layer may facilitate a robust and high wettability (due to a comparatively lower melting-point) during the bonding process, thereby contributing to a stable interface. Particularly when used in a combination, the nickel/tin layer (preferable the nickel/tin/nickel layer) structure may provide a synergistic effect, for example, the (outer) nickel layer may serve as a foundational element for offering a mechanical strength and diffusion barrier property, while the (intermediate) tin layer may ensure an optimal solderability and reliable electrical contact. Advantageously, this multilayered configuration may promote a reliability of the connection structure, thereby facilitating an efficient and reliable interconnect structure within a component carrier.

In an embodiment, a roughness of the exposed surface of the at least one pad and/or of the at least one pillar is different than a roughness of an unexposed extremity of the respective at least one pad and/or of the (respective) at least one pillar. In the context of the present application, the term "roughness" may particularly refer to a small-scale irregularity or deviation from an ideal flat surface. In this regard, the exposed surface of the at least one pad and/or of the at least one pillar may preferably have a lower surface roughness (e.g., a smoother surface) than that of the opposed and unexposed extremity of the respective pad and/or of the respective pillar. This structural feature may be the footprint of a manufacture step such as a polishing process. Advantageously, this arrangement may facilitate a uniform metal layer deposition, e.g., by providing a substantially flat, even surface complying with flatness requirements for subsequent plating or deposition. Hence, a consistent and uniform formation of the connection structure can be obtained thereon. Alternatively, the exposed surface of the at least one pad and/or of the at least one pillar may have a higher surface roughness (e.g., a comparatively rougher surface) than that of the opposite unexposed extremity of the respective pad and/or of the respective pillar. This slightly increased surface roughness may (alternatively) enhance mechanical interlocking (i.e., improved adhesion through surface texture) between the exposed surface and a metal layer to be deposited thereto (e.g., a thin metal layer of the connection structure).

In an alternative or additional embodiment, the roughness of the exposed surface of the at least one pad and/or of the at least one pillar is different than a roughness of an unexposed extremity of the respective (adjacent) connected at least one pillar and/or (of the respective adjacent connected) at least one pad. Likewise, a variation in surface roughness can be adapted (or optimized) to enhance specific functional properties and/or the process footprint, such as providing a smoother region for optimized electrical contact or increasing surface texture to improve structural adhesion at the exposed surface. Preferably, the exposed surface of the at least one pad and/or of the at least one pillar may have a comparatively lower surface roughness to support both a uniform formation of the metal layer (e.g., the connection structure) deposited thereto and a reliable electrical performance across the overall connection structure (in addition this can also depend of the roughness of the top of the temporary carrier and/or copper foil).

In an embodiment, the connection structure comprises an electrically conductive layer structure. For instance, the connection structure may comprise or consist of a metal or metallic material to facilitate an electrical and/or mechanical connection. In another embodiment, the connection structure comprises a metal layer structure, in particular a bulk metal layer structure, more in particular a Ni and/or Sn layer. For example, the connection structure may include or be formed from a (thin) metal layer, such as copper, gold, silver, nickel, aluminium, or similar materials, to provide an improved electrical conductivity, corrosion resistance, and/or mechanical stability. Preferably, the connection structure may comprise or consist of a metal material, particularly copper, consistent with a material of the at least one electrically vertical connection and also of the at least one electrically conductive layer structure. In this regard, utilizing a bulk metal layer structure may enhance a mechanical stability and electrical performance, thereby improving the overall reliability of a component carrier.

In an additional or alternative embodiment, the connection structure comprises an intermetallic compound. Such intermetallic compound may form at the interface between metal layers, e.g., between nickel and tin layers, during lamination. More specifically, tin atoms may diffuse into the adjacent nickel layer(s) (and/or vice versa) and may form several stable intermetallic compounds (such as Ni₃Sn₄, Ni₃Sn₂, or NiSn) at the interface. In some embodiments, a symmetric (intermetallic) structure may be formed in the connection structure with intermetallic compounds in the nickel/tin/nickel layer structure. These intermetallic compounds may enhance a mechanical strength and thermal stability of the connection structure, while also improving an electrical conductivity thereof. Advantageously, this design approach may be especially beneficial for a high-density multilayer interconnect structure integrated with one or more component carriers.

In another embodiment, the connection structure comprises at least one nanowire. In this regard, an inclusion of one or more nanowires may significantly enhance an electrical conductivity and mechanical robustness of the connection structure due to their high aspect ratio and superior electron transport property. The nanowire may comprise or consist of a conductive material, such as copper, silver, gold, or a combination thereof, and may be integrated into the electrically vertical connection structure(s) to facilitate an efficient current flow and reinforce mechanical stability.

In an embodiment, the (plurality of) electrically conductive layer structures and/or the at least one electrically vertical connection comprises a first conductive material, in particular copper. For instance, the plurality of electrically conductive layer structures and the at least one electrically vertical connection comprise a same conductive material, preferable copper. Advantageously, this may promote a firm connection and thus a good reliability of a component carrier. In a further embodiment, the connection structure comprises a second conductive material. For instance, the connection structure may comprise a distinct second conductive material from the first conductive material, such as involving nickel and/or tin or intermetallic compounds thereof. Alternatively, the second conductive material may be same as the first conductive material. More specifically, the second conductive material has a lower melting point than the first conductive material. This configuration may facilitate a selective bonding process, such as soldering, in which the lower-melting-point material (e.g., tin) melts and forms a bond without affecting a structural integrity of the higher-melting-point material (e.g., copper). In an example, this may not affect the insulating layers or the whole stack either. This approach may enable a process control during bonding, thereby improving a reliability of an interconnect structure within a component carrier.

In an embodiment, the component carrier further comprises a plurality of electrically insulating layer structures, wherein each of the plurality of electrically insulating layer structures comprises at least one electrically vertical connection encapsulated by respective dielectric material, wherein the at least one electrically vertical connection respectively comprises at least one pad and at least one pillar connected one to another, wherein the at least one pad is exposed at a first main surface of at least one of the plurality of electrically insulating layer structures and the at least one pillar is exposed at a second main surface of the at least one of the plurality of electrically insulating layer structures, wherein the exposed surface of the at least one pad and/or of the at least one pillar comprises a respective connection structure configured to be connected with the at least one electrically vertical connection of the adjacent one of the plurality of the electrically insulating layer structures.

More specifically, the component carrier may comprise a plurality of electrically vertical connections embedded within or encapsulated by at least two (e.g., first and second) electrically insulating layer structures. For instance, the plurality of electrically vertical connections may be arranged adjacent to each other, in particular oriented in parallel along the vertical direction. Moreover, the plurality of electrically vertical connections may comprise at least one pad array and at least one pillar array that are arranged on top of each other (in the vertical direction), preferably vertically aligned with each other, and vertically penetrate through or encapsulated by the first and second electrically conductive layer structures. As used herein, each of the pad and pillar arrays may not have any limitation imposed on the stacking number. Preferably, a pair of at least one pad array and at least one pillar array may be vertically stacked one above another, preferably vertically aligned with each other, and continuously penetrate through or encapsulated by each of the first and second electrically conductive layer structures. Advantageously, this may establish a high-density (but very design-flexible) interconnect structure within a component carrier and/or modular stacked layers also due to the direct contact of the dielectric materials encapsulating the respective electrically vertical connections.

In another embodiment, the at least one pad (array) and/or the at least one pillar (array) may be coaxial or off-set in a horizontal direction. As used herein, the horizontal direction may particularly be perpendicular to the stack direction. In some embodiments, the at least one pad (array) and/or the at least one pillar (array) may be coaxial. In this regard, a high-quality vertical connection may be provided with a very small misalignment, thereby eventually improving the overall performance of a component carrier. Alternatively, the at least one pad (array) and/or the at least one pillar (array) may be offset one to each other. Accordingly, the offset vertical connection structure may enable an efficient and reliable (yet design-flexible) electrical connection. For example, the vertical connection structures may be electrically connected by a (vertical or horizontal) metal trace. In a further embodiment, the pitch of the at least one pad (array) at one (upper) main surface of the component carrier may be different (smaller) than the pitch of the at least one pad (array) at another (bottom) main surface of the component carrier, due to the offset vertical connection structure. In an embodiment, the pillars can be offset toward one direction, so that they can be used as a part of a redistribution structure.

In a further embodiment, the respective dielectric material may encapsulate circumferential sidewalls and expose upper surface(s) of the at least one pad (array) at a first main surface of each of the first and second electrically insulating layer structures. Similarly, the respective dielectric material may encapsulate circumferential sidewalls and expose bottom surface(s) of the at least one pillar (array) at a (opposing) second main surface of each of the first and second electrically insulating layer structures. Moreover, the exposed upper surface(s) of the at least one pad (array) and/or the expose bottom surface(s) of the at least one pillar (array) may comprise or consist of one or more connection structures that may be electrically (and/or structurally) connected to one or more adjacent pads and/or pillars of different layers. In this regard, the connection structure may function to provide an electrical communication among the plurality of electrically vertical connections (particularly through the diffusion layer in between). Advantageously, the connection structure may facilitate an efficient vertical interconnection between different layers or stacked components within a component carrier. Hence, this configuration can ensure seamless signal transmission and power distribution through a multilayered interconnection, especially supporting a complex circuit design and high-density integration. In another embodiment, the exposed surface of the at least one pad and/or of the at least one pillar is directly connected with the at least one electrically vertical connection of the adjacent one of the plurality of the electrically insulating layer structures. For instance, the exposed surface of the at least one pad and/or of the at least one pillar is structurally and electrically connected to the adjacent pad and/or pillar of two adjacent layers, without any connection structure in between. Advantageously, this configuration may ensure a stable and continuous electrical connection within a component carrier.

In an embodiment, the connection of two adjacent electrically vertical connections is configured as providing a hybrid bonding, in particular a copper-copper bonding, and a dielectric-dielectric bonding, provided between two adjacent electrically insulating layer structures. In general, the component carrier may comprise a hybrid bonding, for example a copper-copper bonding and a dielectric bonding. In this regard, the copper-copper bonding may facilitate a robust electrical interconnection with low contact resistance. Additionally, the dielectric bonding may ensure a structural integrity and electrical insulation between two adjacent layers. Preferably, the component carrier may comprise a hybrid bonding, for example, an intermetallic bonding and a dielectric bonding. Said hybrid bonding can be obtained for example by a recess between the external surface of the insulating layer structure and the exposed encapsulated at least one pad or at least one pillar so that, when increasing the temperature (and the pressure) during the lamination of the two adjacent electrically vertical connections and the respective encapsulating dielectric materials, the expansion of the material of the two adjacent electrically vertical connections result in a respective metal-metal bonding, whereas the pressure between the dielectric materials results in a dielectric-dielectric bonding. In this regard (also described above), the intermetallic bonding may enhance a mechanical strength and thermal stability of the connection structure. Advantageously, this hybrid bonding approach may enable a high-density and improved electrical performance of an (in particular multilayer) interconnect structure within a component carrier.

In an embodiment, at least one pillar is connected to one of the plurality of electrically conductive layer structures. Additionally or alternatively, at least one pillar in one of the at least one (of the plurality of) electrically insulating layer structure(s) is connected to at least one pad in one of the adjacent electrically insulating layer structure through the connection structure. Advantageously, this configuration may facilitate a robust electrical and mechanical interconnection between adjacent layers. In an additional or alternative embodiment, the (respective) dielectric material of two adjacent of the plurality of electrically insulating layer structures are intermingled one to another at a contact area. Advantageously, this intermingling region can improve an adhesion and structural integrity of the multilayer assembly, thereby contributing to the overall reliability of a component carrier.

In an embodiment, at least one of the plurality of electrically vertical connections comprises a vialess electrically conductive layer structure. Similar to what is described above, the at least one of the plurality of electrically vertical connections, particularly those embedded in the second electrically insulating layer structure, may be free from a tapered-shaped feature (which may typically refer to a standard laser via). In this regard, the at least one of the plurality of electrically vertical connections can exhibit a uniform geometric profile, for example, having a substantially straight sidewall and/or being free of a slanted shape. Additionally (also preferably), the uniform geometric structure, like copper pillar, may have a diameter (width) less than 60 µm, in particular less than 30 µm. Advantageously, this configuration may facilitate an efficient and reliable multilayer interconnect structure within a component carrier, with an eventual increasing of density of electrically vertical connections.

In an embodiment, the component carrier further comprises a surface finishing layer provided on the (or both) exposed surface(s) of the at least one electrically vertical connection, in particular an external surface (e.g., an exterior exposed surface) of the at least one pad and/or (of) the at least one pillar of an (or both) outermost layer(s). For instance, a layer of a solder resist (for example a solder mask) may be applied on one or both outermost layers of the component carrier layer stack to selectively expose an exterior surface (portion) of the at least one pad and/or of the at least one pillar. According to one embodiment, a surface finishing layer, for example one of ENIG, ENIPIG, OSP, may be applied onto the exposed exterior surface (portion) of the at least one pad and/or of the at least one pillar. In some embodiments, the expose exterior surface (portion) of the at least one pad and/or of the at least one pillar may also comprise or consist of a connection structure that may be electrically connected to or coupled to an external coupling terminal of a further element. For example, a ball grid array (BGA) may be provided as the external coupling terminal. Such a surface finish treatment may function to protect the exposed surface (portion) of the at least one electrically vertical connection and enable a stable joining process with one or more components, for instance by soldering.

In an embodiment, the exposed surface of the at least one pad or of the at least one pillar flushes with a main surface of the first electrically insulating layer structure, in particular the main surface opposed to that where the connection structure is exposed. For example, the expose surface of the at least one pad or of the at least one pillar without the connection structure formed thereon may flush with the respective main surface of the first electrically insulating layer structure. Advantageously, this flush alignment may enable a smooth surface to facilitate a subsequent surface finish treatment (as described above).

The flush between the at least one pad or the at least one pillar with the main surface of the first electrically insulating layer structure may be the footprint of a planarization step (i.e. grinding and polishing) on the exposed electrically vertical connection and the respective encapsulating dielectric material of the first electrically insulating layer structure. In this regard, a surface interconnect structure may be obtained within a component carrier. In a further embodiment, each of the electrically vertical connections of the at least one electrically insulating layer structure are fully encapsulated by the respective dielectric material except the exposed surfaces. This complete encapsulation may provide an (fully) electrical isolation and environmental shielding for each of the electrically vertical connections, while the exposed surfaces may ensure a reliable electrical interfacing with adjacent conductive layers or connection structures. Hence, such a configuration can ensure a structural integrity and long-term reliability of a component carrier, particularly in high-density multilayer assemblies.

In an embodiment, the component carrier is configured as a bridge, in particular configured to connect at least two components one to another. For instance, the component carrier may be provided with a (high-density) multilayer interconnect structure where a plurality of electrically vertical connections are embedded within or encapsulated by multiple electrically insulating layer structures. This multilayer interconnect structure may serve as a conductive bridge, such as an interposer, that connects at least two components (for example, semiconductor chips) to one another for facilitating an efficient signal routing between them; the connection of the two components may be preferably done connecting the electrically vertical connections one to each other creating bridging electrically connecting paths, preferably using a wiring structure provided in the stack or in a further component connected to the electrically vertical connections.

More specifically, the at least two components are interconnected with each other by the plurality of electrically conductive layer structures connecting to the exposed pad and/or the exposed pillar. Similar as what is described above, the multilayer interconnect structure may further allow the at least two components to be electrically connected with each other and to an external coupling terminal of a further element (for example a mainboard of an electronic device). Such bridge configuration can be realized by connecting the plurality of electrically conductive layer structures to the exposed pad and/or the exposed pillar (in particular through one or more connection structures). In this regard, this bridge configuration may further enable a high-density routing and improved signal integrity within a flexible circuit design. As a result, this design approach may ultimately contribute to a more reliable and efficient interconnection system, suitable for high-performance electronic applications.

In an embodiment, the at least two components are connected to a further component carrier, located on another side of the stack, by the plurality of electrically conductive layer structures connecting to the exposed pad and/or the exposed pillar. More specifically, the at least two components (for example, semiconductor chips) are electrically connected to each other on one main surface of the stack, and are electrically connected to or coupled to a further component carrier (for example a printed circuit board or IC substrate) located on another (opposed) main surface of the stack through the above-mentioned electrically vertical connections in between. Alternatively (also preferably), the plurality of electrically conductive layer structures may be provided within the further component carrier and be electrically connected to the exposed pad and/or the exposed pillar (in particular through one or more connection structures) within the (present) component carrier. In this regard, an efficient and reliable multilayer interconnect structure can be provided in a flexible design within a component carrier.

In an embodiment, the component carrier comprises a soldering structure on at least one main surface of one of the plurality of electrically insulating layer structures, which is provided on an outmost layer of the stack. This soldering structure may facilitate an attachment of an external component or module, thereby ensuring a reliable electrical and mechanical connection. The placement on the outermost layer may further allow for an efficient thermal management and ease of assembly, contributing to the overall performance and durability of a component carrier.

In an embodiment, the component carrier has a coreless structure. For instance, the plurality of electrically insulating layer structures, in particular the first and second electrically insulating layer structures as a whole are together configured as a coreless substrate, such as a coreless layer structure. In this regard, when integrated with the plurality of electrically vertical connections, a compact component carrier can be provided with a reliable and efficient single or multilayer interconnection structure. Meanwhile, the stiffness of the interconnection structure may be ensured.

In an embodiment, the method comprises providing a carrier, in particular a temporary carrier, to support a preform of the stack, in particular manufacturing a first stack on a first main surface of the carrier and manufacturing a second stack on a second main surface of the carrier, in particular opposed to the first main surface. Advantageously, this approach may enable a symmetrical formation of the first and second stacks on both sides of the carrier, thereby facilitating a (coreless) creation of a multilayer structure with an enhanced mechanical stability for subsequent processing steps. Herein such symmetrical design can help balance internal stresses during manufacturing, thereby improving overall structural integrity.

In an embodiment, the method comprises forming at least one pad and/or at least one pillar in the stack provided on the respective main surface of the carrier. More specifically, the method further comprises forming the at least one pad onto the at least one pillar or forming the at least one pillar onto the at least one pad, in particular by a plating process, more in particular (via) galvanic plating. For example, the at least one pad and/or the at least one pillar may be formed from any suitable metal material, preferably copper, using an electroplating, electroless plating, or other deposition techniques. In particular, the at least one pad and/or the at least one pillar may be formed via galvanic plating. Advantageously, this process may offer a high deposition rate, a uniform layer thickness, and excellent material properties during a plating process.

In a preferable embodiment, the at least one pad or the at least one pillar may be formed by lithographic techniques combining with a plating process to achieve a high precision and well-defined pattern. Subsequently, the adjacent connected at least one pillar or at least one pad may be formed through a self-aligned process. By way of example, a well-defined pad array is first patterned, onto which a high-resolution pillar array can be well aligned. Alternatively, the process may be reversed, where the self-aligned pad array may be formed onto top of the well-defined pillar array. Advantageously, this approach can allow for a precise formation of vertically stacked pad and pillar arrays, thereby ensuring a robust electrical conductivity and mechanical stability within an interconnect structure of a component carrier.

In an embodiment, the method comprises encapsulating the formed at least one pad and at least one pillar with a dielectric material forming at least one of the plurality of electrically insulating layer structures. The dielectric material may be formed using any suitable process, such as lamination, coating, or curing, and with any suitable material. Preferably, the dielectric material may comprise an at least partially uncured material, such as an uncured or partially cured resin. This encapsulation process may have several advantages, such as providing an electrical isolation for the conductive features (e.g., the formed at least one pad and at least one pillar), and further providing a mechanical support and protection against environmental factors such as moisture and contaminants. In an embodiment, the method comprises plating the connection structure onto the at least one pad and/or the at least one pillar, in particular providing a polishing process before the plating. In this regard, the polishing process, such as physical grinding or chemical thinning (for example, chemical mechanical polishing, CMP, or chemical etching) can be employed to reduce a surface roughness and comply with flatness requirements for a further plating. Afterwards, a plating process may be applied to deposit the connection structure (for example a thin metal layer of nickel and/or tin) onto the exposed top surface of the at least one pad and/or of the at least one pillar. The plating of the connection structure may be carried out using any suitable process, such as electroplating or electroless plating, to deposit a conductive layer with a precise thickness and uniformity. This approach may enhance an electrical conductivity and mechanical reliability of an interconnect structure within a component carrier.

In an embodiment, the method comprises forming, in particular laminating, the stack by at least three parts, in particular wherein two parts provided on an outermost layer of the stack comprises a surface finishing layer and a soldering structure. In an additional or alternative embodiment, an inner part may comprise at least two of the plurality of the electrically insulating layer structures laminated and connected with each other by the exposed at least one pad and at least one pillar. This arrangement may facilitate a multilayer interconnection structure within a component carrier. Additionally, the combination of an outer surface finishing and an internal laminated structure may ensure a structural integrity of the multilayer interconnection structure within the component carrier. In an embodiment, the method comprises providing two adjacent inner electrically insulating layer structures, wherein the two adjacent inner electrically insulating layer structures comprise at least partially uncured resin before lamination. In this regard, the presence of at least partially uncured resin may allow for an improved adhesion between the two adjacent inner layers during lamination. Advantageously, this approach may be particularly advantageous for achieving a high-reliability component carrier with complex multilayer configurations.

In an embodiment, the component carrier is shaped as a plate. This contributes to the compact design, wherein the component carrier nevertheless provides a large basis for mounting components thereon. Furthermore, in particular a naked die as an example for an embedded electronic component, can be conveniently embedded, thanks to its small thickness, into a thin plate such as a printed circuit board.

In an embodiment, the component carrier is configured as one of the group consisting of a printed circuit board, and a substrate (in particular an IC substrate).

In the context of the present application, the term "printed circuit board" (PCB) may particularly denote a component carrier (which may be plate-shaped (i.e. planar), three-dimensionally curved (for instance when manufactured using 3D printing) or which may have any other shape) which is formed by laminating several electrically conductive layer structures with several electrically insulating layer structures, for instance by applying pressure, if desired accompanied by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers). In an embodiment, the plurality of electrically insulating layer structures comprise at least one of the group consisting of resin (such as rein-forced or non-reinforced resins, for instance epoxy resin or Bismaleimide-Triazine resin, more specifically FR-4 or FR-5), cyanate ester, polyphenylene derivate, glass (in particular glass fibers, multi-layer glass, glass-like materials), prepreg material, polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg or FR4 are usually preferred, other materials may be used as well. For high frequency applications, high-frequency materials such as polytetrafluoroethylene, liquid crystal polymer and/or cyanate ester resins may be implemented in the component carrier as electrically insulating layer structures.

In an embodiment, the at least one electrically conductive layer structure comprises at least one of the group consisting of copper, aluminum, nickel, silver, gold, palladium, and tungsten. Although copper is usually preferred, other materials or coated versions thereof are possible as well, in particular coated with supra-conductive material such as graphene.

In an embodiment, the component carrier is a laminate-type body. In such an embodiment, the semifinished product or the component carrier is a compound of multiple layer structures which are stacked and connected together by applying a pressing force, if desired accompanied by heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier. In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

### Brief Description of the Drawings

The aspects defined above, and further aspects of the invention are apparent from the examples of embodiment to be described hereinafter and are explained with reference to these examples of embodiment.
Figure 1 schematically illustrates a cross-sectional side view of a component carrier having an electrically vertical connection that includes a pad and a pillar, according to an exemplary embodiment of the invention.
Figure 2 schematically illustrates an enlarged sectional view of a connection surface of the component carrier illustrated in Figure 1, according to an exemplary embodiment of the invention.
Figures 3A to 3I schematically illustrates cross-sectional side views of various intermediary stages of manufacturing a component carrier that includes a (coreless) single surface interconnect structure having a connection structure at one-sided surface, according to an exemplary embodiment of the invention.
Figures 4A to 4I schematically illustrates cross-sectional side views of various stages in the manufacture of a component carrier that includes a (coreless) single inner interconnect structure having a connection structure at one-sided or double-sided surface, according to an exemplary embodiment of the invention.
Figures 5A to 5F schematically illustrates cross-sectional side views of various stages in the manufacture of a component carrier that includes a (coreless) multilayer interconnect structure, according to an exemplary embodiment of the invention.
Figures 6A to 6E schematically illustrates cross-sectional side views of various stages in the manufacture of a component carrier, according to an exemplary embodiment of the invention.
Figure 7 depicts a cross-sectional side view of a conventional component carrier with a general embedded trace substrate (ETS) structure.

### Detailed Description of the Embodiments

The illustrations in the drawings are schematic. In different drawings, similar or identical elements are provided with the same reference signs.

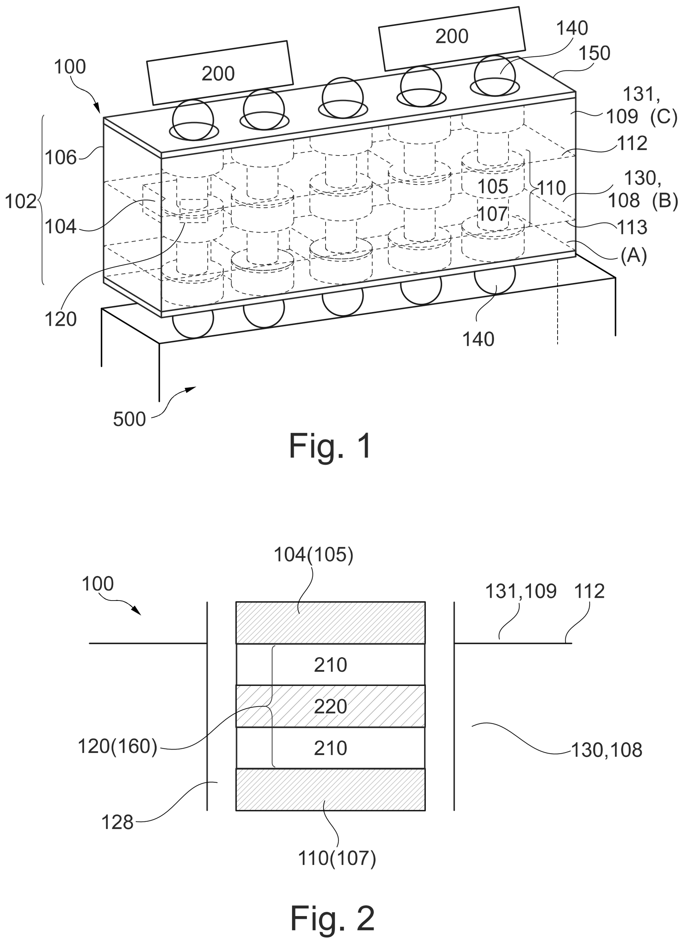

**Figure 1** illustrates a cross-sectional side view of a component carrier 100 according to an exemplary embodiment of the invention.

The illustrated component carrier 100 comprises or consists of a laminated layer stack 102 having a plurality of electrically insulating layer structures 106 and a plurality of electrically conductive layer structures 104. The plurality of electrically conductive layer structures 104 may include patterned copper layers which may form horizontal pads and/or a horizontal wiring structure (trace). Additionally or alternatively, the plurality of electrically conductive layer structures 104 may include vertical through connections such as copper pillars and/or copper filled laser vias. The plurality of electrically insulating layer structures 106 may include an insulating resin, a prepreg or a composition thereof. For example, the plurality of electrically insulating layer structures 106 may comprise a continuous layer that is laminated together under heat and/or mechanical pressure, into which the plurality of electrically conductive layer structures 104 may be patterned or embedded.

In the present context, the term "a horizontal direction" of a body may particularly denote a line or plane that may be substantially parallel to a main extension of the illustrated component carrier 100. In addition, the term "a vertical direction" of the body may particularly refer to a line or plane that may be substantially perpendicular to the main extension of the illustrated component carrier 100. As used herein, the vertical direction may also refer to a stacking direction or a thickness direction of the stack.

Now referring to Figure 1, the plurality of electrically insulating layer structures 106 comprise a first electrically insulating layer structure 130 and a second electrically insulating layer structure 131 stacked above one another in the stacking direction. As illustrated in Figure 1, the first electrically insulating layer structure 130 has a first main surface 112 (which may also refer to an upper surface as shown in Figure 1) and a second main surface 113 (which may also refer to a bottom surface as shown in Figure 1) that are opposite to each other. More specifically, the second electrically insulating layer structure 131 is stacked upon the first main surface 112 of the first electrically insulating layer structure 130. Additionally or alternatively, a third electrically insulating layer structure may be (further) stacked upon the second main surface 113 of the first electrically insulating layer structure 130.

In the present context, the term "main surface" of a body may particularly denote one of two largest opposing surfaces of the body that extends along a main axis or dimension of the body. As shown in Figure 1, the main surface of the component carrier 100 may particularly refer to a top main surface or a bottom main surface being substantially parallel to the main extension of the illustrated component carrier 100. The main surface(s) may be structurally connected by circumferential sidewalls or edges. As such, the first main surface 112 and the second main surface 113 of the first electrically insulating layer structure 130 may be substantially parallel to the main extension of the illustrated component carrier 100.

Still referring to Figure 1, the illustrated component carrier 100 includes at least one electrically vertical connection 110 embedded in the first electrically insulating layer structure 130. Moreover, the at least one electrically vertical connection 110 comprises at least one pad 105 (which may particularly refer to a metal pad, such as a copper pad) and at least one pillar 107 (which may particularly refer to a metal pillar, such as a copper pillar). A material of the at least one pad 105 and of the at least one pillar 107 may be a conductive material such as copper, aluminum, silver, tin, gold, nickel, lead, titanium, or alloys thereof. As further illustrated in Figure 1, the at least one pad 105 and the at least one pillar 107 are stacked on top of each other and electrically connected to each other in the vertical direction. The at least one pad 105 and the at least one pillar 107 are further vertically encapsulated by a first dielectric material 108 of the first electrically insulating layer structure 130. More specifically, the first dielectric material 108 encapsulates circumferential sidewalls (and a portion of a bottom surface) and exposes an upper surface of the at least one pad 105 at the first main surface 112 of the first electrically insulating layer structure 130. Additionally, the first dielectric material 108 also encapsulates circumferential sidewalls and exposes a bottom surface of the at least one pillar 107 at the second main surface 113 of the first electrically insulating layer structure 130. In other words, a thickness of the first electrically insulating layer structure 130 is equal to a sum height of the at least one pad 105 and the at least one pillar 107. Meanwhile, the exposed upper surface of the at least one pad 105 is substantially coplanar with the first main surface 112 of the first electrically insulating layer structure 130. The exposed bottom surface of the at least one pillar 107 is substantially coplanar with the second main surface 113 of the first electrically insulating layer structure 130. In this regard, the exposed upper surface of the at least one pad 105 and the exposed bottom surface of the at least one pillar 107 may provide a flat plane to facilitate a reliable bonding to a component (or element) within the second electrically insulating layer structure 131 and/or other adjacent layers.

In the connected state according to Figure 1, the at least one pad 105 may generally be a flat, planar conductive structure, designed to provide a broad surface for electrical and mechanical connections. In contrast, the at least one pillar 107 may generally be a columnar conductive structure, extending vertically to facilitate inner layer (or interlayer) connections. Typically, the at least one pad 105 has a greater contact surface area compared to the at least one pillar 107, thereby enhancing mechanical stability and electrical conductivity at the interface.

Now again referring to Figure 1, the exposed upper surface of the at least one pad 105 comprises or consists of a connection structure 120. More specifically, the at least one pad 105 comprises or consists of in its upper portion the connection structure 120 being structurally and electrically connected to at least one of the plurality of electrically conductive layer structures 104. Additionally or alternatively, the exposed bottom surface of the at least one pillar 107 may comprise or consist of the connection structure 120 that may be structurally and electrically connected to one electrically conductive layer structure 104.

In the example shown in Figure 1, the at least one electrically conductive layer structure 104 may be provided in the first electrically insulating layer structure 130. Alternatively, the first electrically insulating layer structure 130 can include any number of electrically conductive layer structures 104. In some examples, the at least one electrically conductive layer structure 104 can be or include, e.g., a metal line or pattern, and can be formed on and/or through the first electrically insulating layer structure 130 to contact the connection structure 120 of the respective exposed pad 105 and/or pillar 107. The at least one electrically conductive layer structure 104 may comprise or consist of, for example, copper, titanium, tungsten, aluminium, or the like. For instance, the at least one electrically conductive layer structure 104 is made of copper. Advantageously, a material of the at least one pad 105 (also the at least one pillar 107) and of the at least one electrically conductive layer structure 104 may be the same, which may promote a firm connection in between, thereby ensuring a good reliability of the component carrier 100.

In the example shown in Figure 1 as well, the connection structure 120 is a connection interface between the exposed upper surface of the at least one pad 105 and the at least one electrically conductive layer structure 104. In other words, the at least one pad 105 having the exposed upper surface is interfaced with the at least one electrically conductive layer structure 104 (and/or the at least one pillar 107) in the second electrically insulating layer structure 131 through the connection structure 120. In this regard, the connection structure 120 may function to provide electrical communication between the at least one electrically vertical connection 110 and the at least one electrically conductive layer structure 104.

Although the connection structure 120 is formed only on the exposed upper surface of the at least one pad 105 in the example of Figure 1, it is alternatively also possible that the connection structure 120 is present on both facing (exposed) surfaces of the at least one pad 105 and the at least one electrically conductive layer structure 104. As illustrated in Figure 1, an exterior planar (exposed) surface portion of the at least one pad 105 (in particular with the connection structure 120) and of the first electrically insulating layer structure 130 is coplanar, i.e., at the same vertical level. Additionally, an exterior planar (exposed) surface portion of the at least one electrically conductive layer structure 104 and of the second electrically insulating layer structure 131 is coplanar, i.e., at the same vertical level. In other words, a connection area between the at least one pad 105 having the exposed upper surface and the at least one electrically conductive layer structure 104 is coplanar with a further connection area between the first electrically insulating layer structure 130 and the second electrically insulating layer structure 131. In this regard, a substantially flat connection surface between the first electrically insulating layer structure 130 and the second electrically insulating layer structure 131 may ensure a reliable electric connection as well as an avoidance of cracks.

As further illustrated in Figure 1, the first dielectric material 108 exposed at the first main surface 112 of the first electrically insulating layer structure 130 is directly contacted with the second dielectric material 109 of the second electrically insulating layer structure 131. The first dielectric material 108 may include non-organic materials such as silicon oxide, silicon oxynitride, and the like. In some examples, the first dielectric material 108 may include materials such as an epoxy resin, a molding underfill, and the like. The second dielectric material 109 may include any suitable material same as or different from the first dielectric material 108.

With continuing reference to Figure 1, the illustrated component carrier 100 comprises additionally a plurality of electrically vertical connections 110 embedded in or encapsulated by the first electrically insulating layer structure 130. Similarly, each of the plurality of electrically vertical connections 110 comprises at least one pad 105 and at least one pillar 107 stacked on top of each other and electrically connected to each other in the vertical direction accordingly. More specifically, there is provided at least one pad array 105 and at least one pillar array 107 vertically stacked above one to another within and penetrating through the first electrically insulating layer structure 130. The first dielectric material 108 encapsulates circumferential sidewalls of each of the at least one pad array 105 and of the at least one pillar array 107, thereby exposing upper surfaces of the at least one pad array 105 at the first main surface 112 of the first electrically insulating layer structure 130, and further exposing bottom surfaces of the at least one pillar array 107 at the second main surface 113 of the first electrically insulating layer structure 130. Moreover, the exposed upper surfaces of the at least one pad array 105 and/or the exposed bottom surfaces of the at least one pillar array 107 comprise or consist of one or more connection structures 120 being structurally and electrically connected to one or more electrically conductive layer structures 104. The electrically conductive layer structures 104, for example conductive electrodes, metal patterns, or traces, may be redistributed over and/or through the second electrically insulating layer structure 130 and/or other adjacent layers.

By way of examples above, the illustrated component carrier 100 can be provided with a fine, high-density interconnect (HDI) layer, enabling compact routing of electrical signals within the stack and/or to external components. For instance, the plurality of electrically vertical connections 110 (particularly with one or more connection structures 120) embedded in the first electrically insulating layer structure 130 can be utilized as a fine-pitch HDI structure, such as a fan-out circuit used for mounting a flip-chip chip to an external circuit. In this regard, a single surface interconnect structure (that is, having the connection structure 120 in one-sided active surface) featuring a reliable fine pitch can be realized, which is commonly employed in flip-chip chip scale package (FCCSP), such as mobile devices, micro-electromechanical systems (MEMS), or memory chips. Alternatively, a single inner interconnect structure (that is, having the connection structure 120 in one-sided or double-sided active surface) featuring a reliable fine pitch can be realized, which can enable dense interconnect routing within a substrate for one or more semiconductor chips. With continuing still reference to Figure 1, the illustrated component carrier 100 additionally comprises a plurality of electrically vertical connections 110 embedded in the first electrically insulating layer structure 130 and the second electrically insulating layer structure 131. More specifically, the pad array 105 and the pillar array 107 are alternatively stacked above one to another and penetrate through the first electrically insulating layer structure 130 and the second electrically insulating layer structure 131. In the first electrically insulating layer structure 130, the pad array 105 has exposed upper surfaces at the first main surface 112 thereof and the pillar array 107 has exposed bottom surfaces at the second main surface 113 thereof. As such, in the second electrically insulating layer structure 131, the (further) pad array 105 also has exposed upper surfaces at an upper main surface thereof and the (further) pillar array 107 has exposed bottom surfaces at a bottom main surface thereof. Moreover, the exposed upper surfaces of each pad array 105 and/or the exposed bottom surfaces of each pillar array 107 comprise one or more connection structures 120. The connection structures 120 may be structurally and electrically connected to one or more electrically conductive layer structures 140 and/or the adjacent pads 105 (and/or pillars 107) that do not have any connection structures 120 on their exposed surfaces.

By way of examples above, the illustrated component carrier 100 can be provided with a fine, high-density multilayer interconnect structure to create a high-density 3D integration. For instance, the plurality of electrically vertical connections 110 (particularly with one or more connection structures 120) embedded in or encapsulated in the (first and second) electrically insulating layer structures 130, 131 can be utilized as a conductive bridge, such as an interposer, connecting at least two components 200 (such as semiconductor chips) one to another for providing signal routing. Additionally, the at least two components 200 may be further attached to a further component carrier 500 (e.g. an external coupling terminal of a further element such as a mainboard of an electronic device) through the illustrated component carrier 100, for instance through one or more electrically conductive layer structures 104 electrically connecting to the plurality of electrically vertical connections 110. In this regard, a multilayer interconnect structure enabling high-density routing and improved signal integrity (if designed with short interconnects) can be realized through a flexible circuit design. The component carrier 100 may hence be used as an interposer between the semiconductor elements 200 and the further component carrier 500.

Still referring to Figure 1, a surface finishing layer 150 (such as a solder mask/resist) is formed on the two opposing main surfaces of the illustrated component carrier 100 and has openings exposing at least portions of the vertical connection structures 110 (preferably referring to the pad array 105). A surface treatment is further applied onto the exposed vertical connection structures 110. As illustrated in Figure 1, a soldering structure 140 (e.g., solder balls, metal bumps, pillars, or a combination thereof) is redistributed over the openings of the solder mask 150 and electrically (also structurally) connected to each exposed upper surface of the pad array 105 in the second electrically insulating layer structure 131 accordingly. In the example of Figure 1, the soldering structure 140 may ensure soldering of the components 200 to the illustrated component carrier 100. Further, the soldering structure 140 may support correct soldering of the illustrated component carrier 100 on a mounting base below to facilitate an external electrical connection. For example, the soldering structure 140 may be further bonded (or attached) to a further component carrier 500 such as a printed circuit board, a package substrate, a mother board, or the like.

**Figure 2** illustrates an enlarged cross-sectional view of a connection surface of a component carrier 100 according to an exemplary embodiment. In the example of Figure 2, the component carrier 100 may comprise some or all the components and/or structures that are illustrated in Figure 1 above. Regarding this, Figure 2 only demonstrates the connection surface of the component carrier 100 for the sake of simplicity. To put it shortly, Figure 2 illustrates a hybrid interfacial connection between the first electrically insulating layer structure 130 and the second electrically insulating layer structure 131.

More specifically, a hybrid bonding is achieved at the interface, such as a metal-to-metal bonding between the at least one electrically vertical connection 110 and the at least one electrically conductive layer structure 104, as well as a direct dielectric bonding (such as Si-O-Si bonds) between the first dielectric material 108 and the second dielectric material 109. In the example of Figure 2, the hybrid bonding may include a pre-bonding and an anneal, so that the metals in the respective at least one electrically vertical connection 110 inter-diffuse with the metals in the at least one electrically conductive layer structure 104. In particular (also preferably), during this process atomic (inter-)diffusion of metal atoms may occur within the connection structure 120, leading to an intermetallic bonding in between.

As illustrated in Figure 2, the connection structure 120 comprises a diffusion layer 160 at an outmost surface of the at least one electrically vertical connection 110 (specifically referring to the exposed upper surface of the at least one pad 105 as illustrated in Figure 1). The diffusion layer 160 is recessed within a recessed space 128 at the first main surface 112 of the first electrically insulating layer structure 130. In other words, the diffusion layer 160 may define the recessed space 128. More specifically, the recessed space 128 is a cavity or a recess that recesses from the respective main surface 112, 113 of the first electrically insulating layer structure 130 to accommodate and expose the connection structure 120 (associated with the diffusion layer 160). Alternatively, the diffusion layer 160 may be positioned in the recessed space 128 and extend below the respective main surface 112, 113 of the first electrically insulating layer structure 130. In some examples, the diffusion layer 160 may protruding above the main surface 112, 113 of the first electrically insulating layer structure 130 and thus protruding into the first electrically insulating layer structure 130, therefore comprise an anchor-structure. By way of examples, an improved stiffness strength can be provided.

In some examples, the diffusion layer 160 may comprise or consist of a configuration of intermetallic compounds, such as a configuration of copper-nickel alloy, a configuration of copper-tin alloy, a configuration of copper-gold alloy, or the like. Preferably, the diffusion layer 160 may comprise or consist of a nickel/tin or nickel/tin/nickel intermetallic compound. It is to be appreciated that the diffusion layer 160 may comprise or consist of a very thin growth of intermetallic layer(s) involving nickel and tin metal layers, in particular with the nickel/tin/nickel intermetallic compound formation therein. In this regard, a copper-nickel/tin/nickel-copper intermetallic bonding can be achieved at the interface between the at least one electrically vertical connection 110 and the at least one electrically conductive layer structure 104.

For instance, such copper-nickel/tin/nickel-copper intermetallic bonding formed at the interface may exhibit distinct physical and chemical properties (e.g., an enhanced mechanical stability, oxidation resistance, and feasible processing at a lower temperature) when compared to a direct (pure) copper-to-copper bonding.

These differences may arise primarily from the presence of intermetallic compound(s) in the copper-nickel/tin/nickel-copper layer structure. For example, the (outer) nickel layer can act as a (thin) diffusion barrier at the interface, preventing excessive copper diffusion and oxidation at (and/or across) the interface. This may result in an enhanced reliability of the component carrier 100. The presence of (intermediate) tin layer can promote good wettability during a bonding process, thereby leading to a stable interface. Particularly, tin atoms may diffuse into the adjacent nickel layer (or vice versa) and form stable intermetallic compounds (such as Ni₃Sn₄, Ni₃Sn₂, or NiSn) within the diffusion layer 160. More particularly, a symmetric diffusion process may be present within the diffusion layer 160 with intermetallic compounds on both sides of the nickel and tin interfaces. This can ensure a high reliability (without sacrificing conductivity) and improved mechanical strength, while minimizing brittleness if carefully designed. As a result, the connection structure 120 comprising the diffusion layer 160 (particularly with the nickel/tin/nickel layer structure) can ensure excellent electrical characteristics with an improved interconnection reliability at the interface.

In the example of Figure 2, the connection structure 120 comprises the following stacked layers from bottom to top: an external surface of the pad 105 (copper), nickel layer 210, tin layer 220, further nickel layer 210, and the electrically conductive layer structure 104 (copper).

As further illustrated in Figure 2, a direct dielectric bonding is present between the first dielectric material 108 and the second dielectric material 109, in particular by oxide bonding (for example Si-O-Si bonds). This may create a strong, stable and adhesive-free bond at the atomic or molecular level between dielectric surfaces. By adjusting material properties, in particular what concerns the coefficient of thermal expansion (CTE), of the respective dielectric materials 108, 109, interface stress may be reduced or even eliminated. In this regard, a stress-reduced dielectric interface between the two electrically insulating layer structures 130, 131 can be provided to at least reduce or even minimize material stresses in an interior of the stack of the component carrier 100.

Preferably, an intermingling region may be present at the dielectric interface. In this preferred example, the respective dielectric materials 108, 109 may each comprise an at least partially uncured material, such as an uncured or semi-cured resin. By way of example, a gradual transition between the two dielectric materials 108, 109 can be provided, which thereby can avoid an abrupt change of material properties at the interface. Advantageously, this configuration can minimize or even eliminate warpage, delamination, or cracking at the interface, thereby ensuring a high reliability of the component carrier 100.

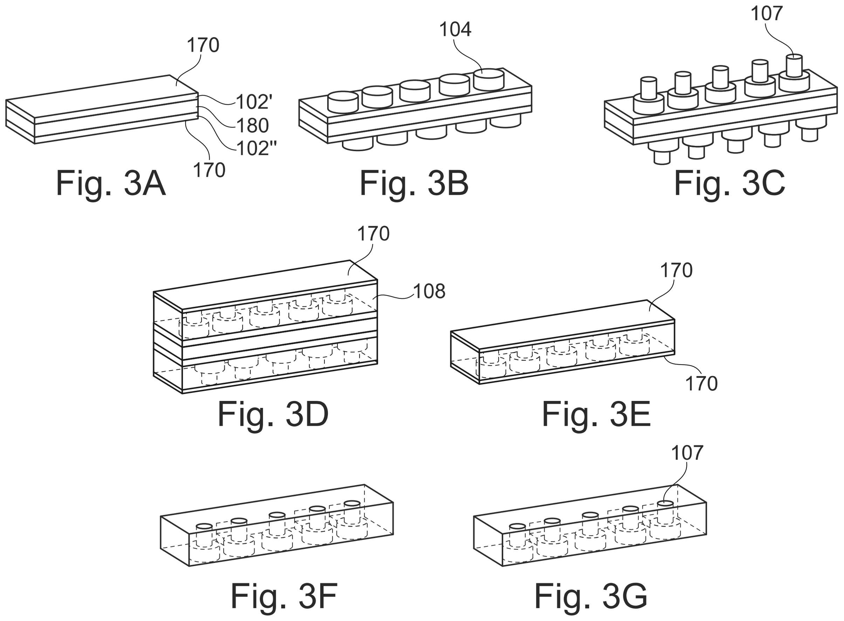

**Figure 3A to 3I** illustrate cross-sectional side views of various stages in the manufacturing of a B-part structure 300 of a component carrier 100, according to an exemplary embodiment of Figure 1. As used herein, the B-part structure 300 of the component carrier 100 may specifically refer to an inner part provided as any (amount of) inner layer of the stack 102 of the component carrier 100 present in Figure 1.

Coreless creation of the component carrier 100 is initiated as shown in Figure 3A by forming a first stack 102' on top of a temporary carrier 180 and a second stack 102" on bottom of the temporary carrier 180. From Figure 3A to 3D, the B-part structure 300 formation is performed on both sides of the temporary carrier 180, however, for a clearer illustration, the B-part structure 300 formation on the bottom side has been omitted.

As illustrated in **Figure 3A**, as a first part of the first stack 102', a copper foil 170 is placed on top of the temporary carrier 180. The temporary carrier 180 may be formed from any suitable insulating structure to provide proper mechanical support during manufacturing. For instance, the temporary carrier 180 is coated with a release layer (not shown) to facilitate delamination (for example, to permit the resulting structure to eventually be removed from the temporary carrier 180). The first stack 102' may be laminated onto the surface of the temporary carrier 180 through a lamination process (e.g., thermal or mechanical pressure).

To pattern well-defined conductive pads and/or traces 104 as described below with reference to **Figure 3B**, it is advantageously possible to apply lithographic techniques and a plating process. Optionally, a seed layer may be applied to facilitate the conductive pads and/or traces 104 formation. The seed layer (not shown) may uniformly cover an entire surface of the first stack 102' and be, preferably, made of copper to facilitate an electrolytic plating of the conductive pads and/or traces 104. The seed layer may be plated using a sputtering or e-beam evaporation process, preferable with a thickness less than 1 µm. Afterwards, a photoresist layer (not shown) is applied onto the first stack 102'. To obtain the well-defined pattern, a photomask alignment and exposure process is carried out. In some examples, an optical measurement, for example optical or scanning electron microscopy (SEM), may be employed to inspect the pattern for defects. During lithographic patterning, the metal material is plated into the patterned regions defined by the photoresist to form the conductive pads and/or traces 104. The conductive pads and/or traces 104 may be any suitable metal, preferable copper, using an electroplating or electroless plating process. After patterning, the remaining photoresist is moved away from the temporary carrier 180.

To provide a high-resolution pillar array 107 aligned to the underlying conductive pads and/or traces 104 as described below with reference to **Figure 3C**, it is advantageously possible to apply a self-aligned process. Before plating, a dielectric or passivation layer (not shown) is formed over the conductive pads and/or traces 104 to insulate and define the pillar array region. The dielectric or passivation layer may be deposited using plasma-enhanced chemical vapor deposition (PECVD) or spin-coating method and may have a desired thickness matching the conductive pads and/or traces 104. Optionally, a seed layer may be applied to facilitate the self-aligned pillar array 107 formation before plating. In a subsequent step, the desired metal material (preferable copper) is electroplating onto the top of the conductive pads and/or traces 104. Thus, the pillar array 107 is directly formed onto the conductive pads and/or traces 104. The pillar array 107 may have a (consistent) diameter less than 60 µm, in particular less than 30 µm. After plating, the dielectric or passivation layer may be removed **Figure 3D** illustrates a dielectric lamination onto the formed conductive pads and/or traces 104 and the pillar array 107. The conductive pads and/or traces 104 and the pillar array 107 are fully encapsulated by a dielectric material 108. More specifically, the dielectric material 108 completely covers a top surface of the pillar array 107 to account for an even surface, and completely covers the lateral surface of the pillar array 107. The dielectric material 108 also completely covers an upper surface of the conductive pads and/or traces 104, and completely covers the lateral surface of the conductive pads and/or traces 104. The dielectric material 108 may be formed using any suitable process, such as lamination, coating, or curing, and with any suitable material. Preferably, the dielectric material 108 may comprise an at least partially uncured material, such as an uncured or semi-cured resin. After dielectric lamination, the copper foil 170 is further laminated onto the dielectric material 108. The electrically vertical connection (including conductive pads and/or traces 104 and the pillar array 107) is encapsulated by dielectric material 108, that can also be recognizable in the final product by the flow lines of the dielectric material 108 (also recognizable by the fillers distribution/direction) and sometime by the rounded shape of this dielectric provided on the sharped corners filled by resin.

**Figure 3E** illustrates a detachment of the temporary carrier 180. Additionally or alternatively, the release layer is then etched away. In this regard, the dielectric layer structure 108 with the formed conductive pads and/or traces 104 and the pillar array 107 therein is sandwiched between the copper foil 170.

**Figure 3F** illustrates a removal of the copper foil 170 from a top surface of the dielectric layer structure 108 and from a bottom surface of the dielectric layer structure 108, for example by etching.

**Figure 3G** illustrates a polishing process related to exposing the pillar array 107 and the conductive pads and/or traces 104. More specifically, the surfaces of the pillar array 107 and the conductive pads and/or traces 104 which are adjacent to the respective main surfaces of the electronic insulating layer structure 130, 131 are exposed by planarization, for example grinding or chemical mechanical polishing (CMP). In an alternative example, the dielectric material 108 may be planarized to below the exposed surface of the pillar array 107 and the conductive pads and/or traces 104.

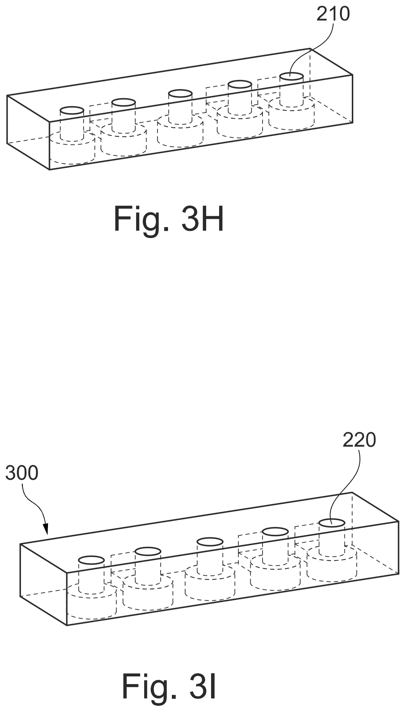

**Figure 3H** illustrates a plating process related to depositing a nickel layer 210 onto the exposed surface of the pillar array 107 and the conductive pads and/or traces 104. The nickel layer 210 may be deposited using any suitable process, such as lithography and electrolytic plating.

**Figure 3I** illustrates a further plating process related to depositing a tin layer 220 onto the plated nickel layer 210. The tin layer 220 may be deposited using any suitable process, such as lithography and electrolytic plating.

In this regard, both exposed electronic conductive layer structures (i.e., the pillar array 107 and the conductive pads and/or traces 104) of the B-part structure 300 is covered by a nickel layer 210 and a tin layer 220. In a further embodiment, at least two or more such B-part structures 300 may be manufactured and stacked one above each other in the thickness direction (not shown) and connected by the connection structure 120 (comprising nickel layer(s) 210 and tin layer 220). That is to say, the exposed pillar array 107 (with a tin layer 220 as the outmost conductive portion) of one B-part structure 300 may be physically and electronically connected to the exposed conductive pads and/or traces 104 (with a tin layer 220 or only the nickel layer 210 as the outmost conductive portion) of a further (and similar) B-part structure 300.

The connection may be processed by any suitable process, such as lamination with heat and pressure. During the lamination process, the insulating material 108 of these B-part structures 300 may be melted to a certain extent which becomes uncured again, so that the insulating material 108 from the main surfaces of adjacent B-part structures 300 (facing each other) may be intermingling with each other and preferably forms a uniformed electronic insulating structure. In this regard, a so-called any (amount of) layer structure could be obtained, as at least two or more such B-part structures 300 may be manufactured and stacked one above each other in the thickness direction, wherein the electrically vertical connection 110 (comprising the pillar 107 and conductive pads and/or traces 104) is encapsulated by the dielectric material 108 of the electrically insulating layer structure 106.

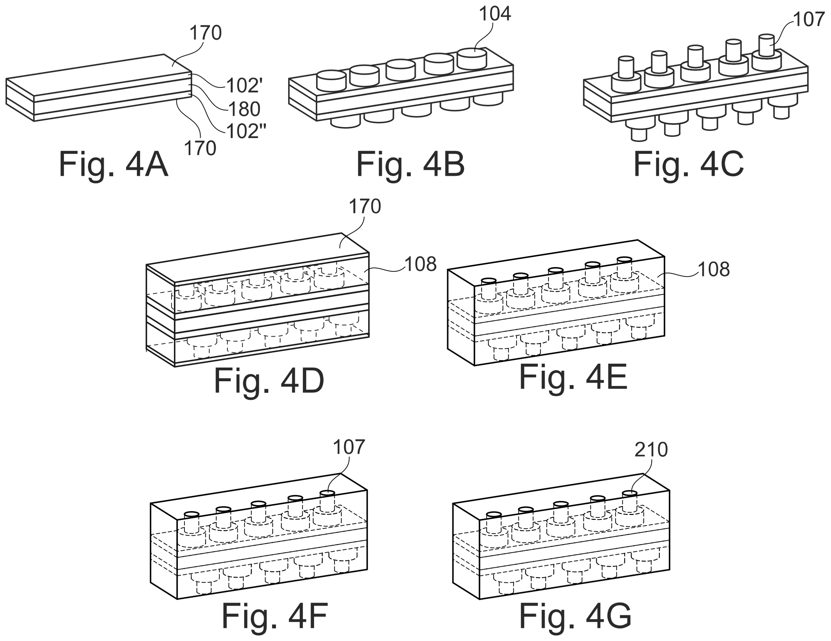

**Figure 4A to 4I** illustrate cross-sectional side views of various stages in the manufacturing of a top A-part structure 400 of a component carrier 100, according to an exemplary embodiment of Figure 1. As used herein, the top A-part structure 400 of the component carrier 100 may specifically refer to an outmost top layer (A-part) provided on the stack 102 of the component carrier 100 present in Figure 1. Figure 4A to 4I illustrate a substantially similar manufacturing process as shown in Figure 3A to 3I. From Figure 4A to 4H, the A-part structure 400 formation is performed on both sides of the temporary carrier 180, however, for a clearer illustration, the A-part structure 400 formation on the bottom side has been omitted.

As illustrated in **Figure 4A**, the first stack 102' is provided onto the top of the temporary carrier 180. As a first part of the first stack 102', a copper foil 170 is placed on top of the temporary carrier 180. In addition, the temporary carrier 180 is coated with a release layer (not shown) to facilitate delamination.

As illustrated in **Figure 4B**, the well-defined conductive pads and/or traces 104 are formed on the temporary carrier 180. Advantageously, a lithographic patterning combining with a plating process is applied for the conductive pads and/or traces 104 formation, which is substantially similar as the manufacturing process as illustrated in Figure 3B above. Alternatively, any other suitable manufacturing processes may be included and employed to form the well-defined conductive pads and/or traces 104.

With reference to **Figure 4C**, the high-resolution pillar array 107 is directly formed on the conductive pads and/or traces 104 as described above. Advantageously, a self-aligned process is applied for the pillar array 107 formation, which is substantially similar as the manufacturing process as illustrated in Figure 3C above. Alternatively, any other suitable manufacturing processes may be included and employed to form the self-aligned pillar array 107.

**Figure 4D** illustrates a dielectric lamination onto the formed conductive pads and/or traces 104 and the pillar array 107. The conductive pads and/or traces 104 and the pillar array 107 are fully encapsulated by a dielectric material 108. The dielectric material 108 completely covers the lateral surface of the pillar array 107. The dielectric material 108 also completely covers an upper surface of the conductive pads and/or traces 104, and completely covers the lateral surface of the conductive pads and/or traces 104. The dielectric material 108 may be formed using any suitable process, such as lamination, coating, or curing, and with any suitable material. Preferably, the dielectric material 108 may comprise an at least partially uncured material, such as an uncured or semi-cured resin. After dielectric lamination, the copper foil 170 is further laminated onto the dielectric material 108.

The electrically vertical connection (including conductive pads and/or traces 104 and the pillar array 107) is encapsulated by dielectric material 108, that can also be recognizable in the final product by the flow lines of the dielectric material 108 (also recognizable by the fillers distribution/direction) and sometime by the rounded shape of this dielectric provided on the sharped corners filled by resin.

**Figure 4E** illustrates a removal of the copper foil 170 from a top surface of the dielectric layer structure 108, for example by etching.

**Figure 4F** illustrates a polishing process related to exposing the pillar array 107. More specifically, the top surface of the pillar array 107 is exposed by planarization, for example grinding or chemical mechanical polishing (CMP). In an alternative example, the dielectric material 108 may be planarized to below the top surface of the pillar array 107.

**Figure 4G** illustrates a plating process related to depositing a nickel layer 210 onto the exposed top surface of the pillar array 107. The nickel layer 210 may be deposited using any suitable process, such as lithography and electrolytic plating.

**Figure 4H** illustrates a further plating process related to depositing a tin layer 220 onto the plated nickel layer 210. The tin layer 220 may be deposited using any suitable process, such as lithography and electrolytic plating.

**Figure 4I** illustrates a detachment of the temporary carrier 180. In this regard, the pillar array 107, exposed to the main surface of the electronic insulating layer structure 131, of the A-part structure 400, is covered by a nickel layer 210 and a tin layer 220. The opposed main surface of the electronic insulating layer structure 131, where the conductive pads and/or traces 104 are facing to, is still covered by the copper foil 170 which remains after the detachment.

Afterwards, a surface finish treatment is applied onto the functional conductive layer of the resulting A-part structure 400.

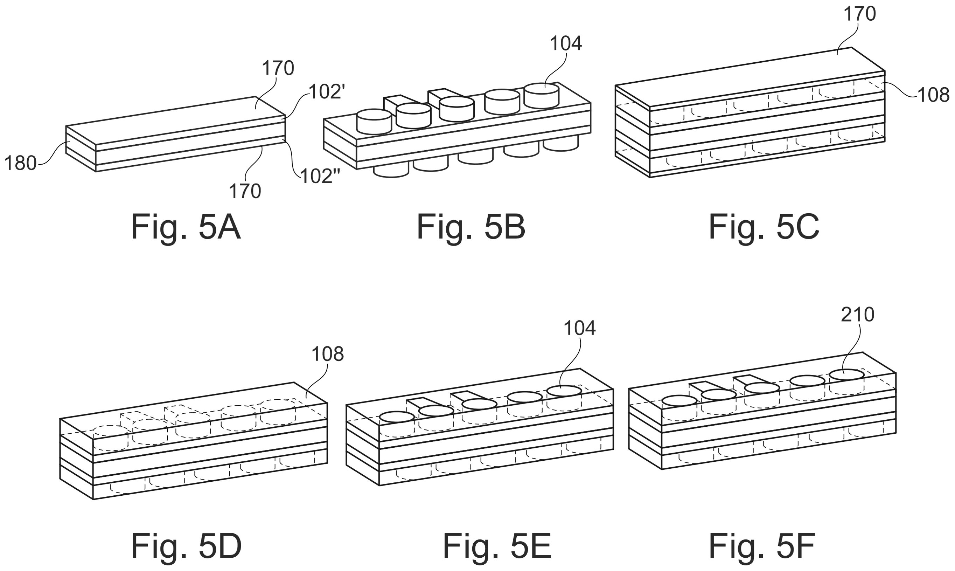

**Figure 5A to 5F** illustrate cross-sectional side views of various stages in the manufacturing of an outer C-part structure for a component carrier 100, according to an exemplary embodiment of Figure 1. As used herein, the outer C-part structure of the component carrier 100 may specifically refer to a bottom part (C-part) provided on an outmost bottom layer of the stack 102 of the component carrier 100 present in Figure 1. Similarly, the outer C-part structure formation is also performed on both sides of the temporary carrier 180, however, for a clearer illustration, the outer C-part structure formation on the bottom side has been omitted.

As illustrated in **Figure 5A****,** the first stack 102' is provided onto the top of the temporary carrier 180. As a first part of the first stack 102', a copper foil 170 is placed on top of the temporary carrier 180. In addition, the temporary carrier 180 is coated with a release layer (not shown) to facilitate delamination.

As illustrated in **Figure 5B****,** the well-defined conductive pads and/or traces 104 are formed on the temporary carrier 180. Advantageously, a lithographic patterning combining with a plating process is applied for the conductive pads and/or traces 104 formation, which is substantially similar as the manufacturing process as illustrated in Figure 3B above. Alternatively, any other suitable manufacturing processes may be included and employed to form the well-defined conductive pads and/or traces 104.

**Figure 5C** illustrates a dielectric lamination onto the formed conductive pads and/or traces 104. The conductive pads and/or traces 104 are fully encapsulated by the dielectric material 108. More specifically, the dielectric material 108 completely covers a top surface and the lateral surface of the conductive pads and/or traces 104. The dielectric material 108 may be formed using any suitable process, such as lamination, coating, or curing, and with any suitable material. Preferably, the dielectric material 108 may comprise an at least partially uncured material, such as an uncured or semi-cured resin. After dielectric lamination, the copper foil 170 is further laminated onto the dielectric material 108.

**Figure 5D** illustrates a removal of the copper foil 170 from the top of the dielectric material 108, for example by etching.

**Figure 5E** illustrates a polishing process related to exposing a top surface of the conductive pads and/or traces 104. The top surface of the conductive pads and/or traces 104 is exposed by planarization, for example grinding or chemical mechanical polishing (CMP).

**Figure 5F** illustrates a plating process related to depositing a nickel layer 210 onto the exposed top surface of the conductive pads and/or traces 104. The nickel layer 210 may be deposited using any suitable process, such as lithography and electrolytic plating.

In this regard, the two semi-finished C-part structures is formed, along with the temporary carrier 180 in between. The exposed top surface of the conductive pads and/or traces 104 of the two semi-finished C-part structures are covered by the connection structure 120 (comprising nickel layer(s) 210 and tin layer 220). A further process shall be applied to the stacked two semi-finished C-part structures, for example the lamination of A-part and/or B-part. The stacked (thicker) layer structures may be robust and reliable to these further process. Afterwards, the temporary carrier 180 is removed and the release layer is then etched away to form the resulting outer C-part structure. Alternatively, the C-part is detached at a very last stage, for example after A-part and B-part have been laminated onto the C-part.

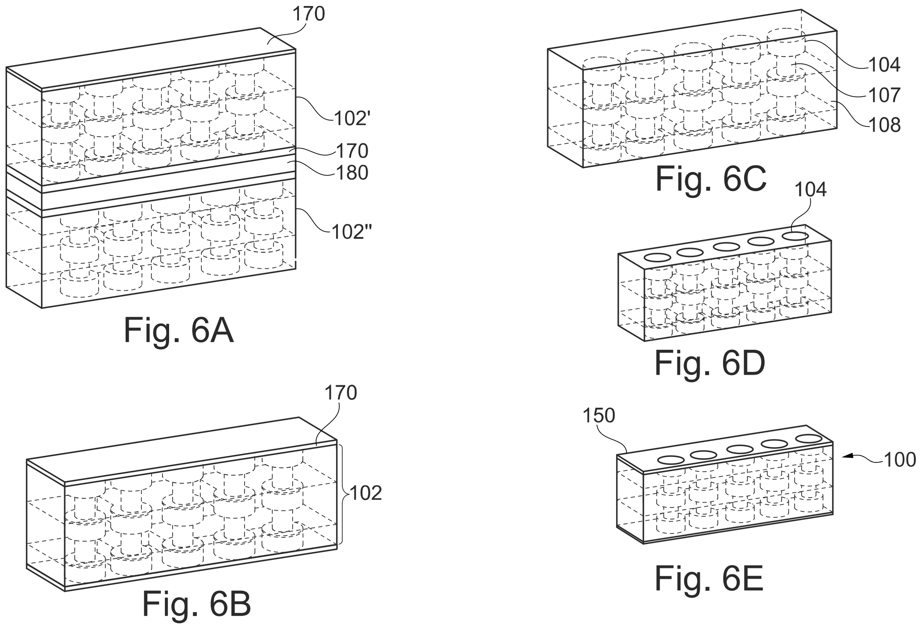

**Figure 6A to 6E** illustrate cross-sectional side views of various stages in the manufacturing of a final product of a component carrier 100, according to an exemplary embodiment of the invention, wherein the modularization of the component carrier may be obtained.

As illustrated in **Figure 6A****,** the final product of the component carrier 100 is laminated with three parts that can be provided by a top part present on an outmost top layer (such as the A-part structure as illustrated from Figure 4A to 4I), an inner part present on any (amount of) inner layer(s) (such as the B-part structure as illustrated from Figure 3A to 3I), and a bottom part present on an outmost bottom layer (such as the outer C-part structure as illustrated from Figure 5A to 5F).

As illustrated in **Figure 6B****,** the temporary carrier 180 is removed. Additionally or alternatively, the release layer is then etched away.

As illustrated in **Figure 6C****,** a removal of the copper foil 170 from both side of the stack 102 is applied.

As illustrated in Figure **6D****,** an optional polishing process related to exposing a top surface of the conductive pads and/or traces 104 is applied. The top surface of the conductive pads and/or traces 104 is exposed by planarization, for example grinding or chemical mechanical polishing (CMP).

**Figure 6E** illustrates a surface treatment. A thin layer of a solder mask 150 is applied on both sides of the stack 102 to form openings. Afterwards, a surface finishing treatment, for example one of ENIG, ENIPIG, OSP, may be applied onto the exposed exterior surface (portion) of the conductive pads and/or traces 104. The expose exterior surface (portion) of the conductive pads and/or traces 104 may also comprise or consist of solder 140 that may be electrically connected to a further element, for example at least one component and a circuit board. The resulting (coreless) component carrier structure 100 thus can be utilized as a conductive bridge (for example an interposer) through which one or more components (for example semiconductor chips) can be electrically connected to each other and further attached to an external circuit board (for example an external package substrate or a mainboard of an electronic device).

In the above detailed description, reference is made to the accompanying drawings, which form a part thereof and in which are shown by way of illustration specific embodiments. In this regard, the term "over" employed in this description regarding a material layer (or layer structure) formed or located "over" a surface maybe used herein to mean that the material layer (or layer structure) be located (e.g. formed, positioned, etc.) "directly on", e.g., in a direct contact with, the implied surface.

As well, it should be noted that the term "comprising" does not exclude other elements or steps and the "a" or "an" does not exclude a plurality.

It should be also noted that reference signs in the claims should not be construed as limiting the scope of the claims.

Implementation of the invention is not limited to the preferred embodiments shown in the figures described above. Instead, a multiplicity of variants is possible which use the solutions shown and the principle according to the invention even in the case of fundamentally different embodiments.

### Reference signs

- 100: Component carrier
- 102: Stack
- 102': First stack
- 102": Second stack
- 104: Electrically conductive layer structure
- 106: Electrically insulating layer structure
- 105: Pad
- 107: Pillar
- 108: First dielectric material
- 109: Second dielectric material
- 110: Electrically vertical connection
- 112: First main surface
113 Second main surface
- 120: Connection structure
- 128: Recessed space
- 130: First electrically insulating layer structure
- 131: Second electrically insulating layer structure
- 140: Soldering structure
- 150: Surface finishing layer
- 160: Diffusion layer
- 170: Copper foil
- 180: Temporary carrier
- 200: Component, semiconductor element
- 210: Nickel layer
- 220: Tin layer
- 500: Further component carrier
- 600: Conventional component carrier
- 604: (Conventional) conductive trace
- 606: (Conventional) dielectric layer
- 610: (Conventional) vias

## Claims

1. A component carrier (100), wherein the component carrier (100) comprises:
a stack (102) having a plurality of electrically insulating layer structures (106) and a plurality of electrically conductive layer structures (104);
at least one electrically vertical connection (110) encapsulated by a dielectric material (108) of a first electrically insulating layer structure (130) of the plurality of electrically insulating layer structures (106) of the stack (102),
wherein the at least one electrically vertical connection (110) comprises at least one pad (105) and at least one pillar (107) connected to each other,
wherein the at least one pad (105) is exposed at a first main surface (112) of the first electrically insulating layer structure (130) and the at least one pillar (107) is exposed at a second main surface (113) of the first electrically insulating layer structure (130);
wherein the exposed surface of the at least one pad (105) and/or the exposed surface of the at least one pillar (107) comprises a connection structure (120) configured to be connected to at least one of the plurality of electrically conductive layer structures (104), and
wherein the dielectric material (108) exposed at the respective main surface of the first electrically insulating layer structure (130) where the connection structure (120) is exposed, is in direct contact with a second electrically insulating layer structure (131) of the plurality of electrically insulating layer structures (106).

2. The component carrier (100) according to claim 1, wherein the component carrier (100) further comprises a plurality of electrically vertical connections (110) in the first electrically insulating layer structure (130), wherein the plurality of electrically vertical connections (110) comprises a plurality of pads (105) and a plurality of pillars (107) connected to each other.

3. The component carrier (100) according to claim 1 or 2,
wherein the at least one electrically vertical connection (110), in particular each of the plurality of electrically vertical connections (110), comprises a vialess electrically conductive layer structure.

4. The component carrier (100) according to any of claims 1 to 3,
wherein the at least one or the plurality of the pad (105) and/or pillar (107) has at least one of the following shapes: cylindrical, rectangular, polygonal; and/or wherein the at least one or the plurality of the pad (105) and/or pillar (107) is free of a slanted shape; and/or
wherein the at least one or the plurality of the pad (105) and/or pillar (107) comprises a straight sidewall.

5. The component carrier (100) according to one of the preceding claims,
wherein the exposed at least one or the plurality of pad (105) and/or the exposed at least one or the plurality of pillar (107) is recessed by a recessed space (128) with respect to the respective main surface of the first electrically insulating layer structure (130),
in particular wherein a diffusion layer (160) is associated to the connection structure (120), said diffusion layer (160) having a coefficient of thermal expansion, lower than a coefficient of thermal expansion of the at least one electrically vertical connection (110) and defining the recessed space (128).

6. The component carrier (100) according to one of the preceding claims, wherein a roughness of the exposed surface of the at least one pad (105) and/or of the at least one pillar (107) is different than a roughness of an unexposed extremity of the respective connected at least one pillar (107) and/or at least one pad (105).

7. The component carrier (100) according to one of the preceding claims,
wherein the connection structure (120) comprises an electrically conductive layer structure; and/or
wherein the connection structure (120) comprises a metal layer structure, in particular a bulk metal layer structure, more in particular a Ni and/or Sn layer; and/or
wherein the connection structure (120) comprises at least one nanowire; and/or wherein the connection structure (120) comprises an intermetallic compound.

8. The component carrier (100) according to one of the preceding claims,
wherein the electrically conductive layer structures (104) and/or the at least one electrically vertical connection (110) comprises a first conductive material, in particular copper; and/or
wherein the connection structure (120) comprises a second conductive material, in particular wherein the second conductive material has a lower melting point than the first conductive material.

9. The component carrier (100) according to one of the preceding claims, further comprising a plurality of electrically insulating layer structures,
wherein each of the plurality of electrically insulating layer structures comprises at least one electrically vertical connection (110) encapsulated by respective dielectric material (108),
wherein the at least one electrically vertical connection (110) respectively comprises at least one pad (105) and at least one pillar (107) connected one to another,
wherein the at least one pad (105) is exposed at a first main surface of at least one of the plurality of electrically insulating layer structures and the at least one pillar (107) is exposed at a second main surface of the at least one of the plurality of electrically insulating layer structures,
wherein the exposed surface of the at least one pad (105) and/or of the at least one pillar (107) comprises a respective connection structure (120) configured to be connected with the at least one electrically vertical connection (110) of the adjacent one of the plurality of the electrically insulating layer structures, in particular
wherein the exposed surface of the at least one pad (105) and/or of the at least one pillar (107) is directly connected with the at least one electrically vertical connection (110) of the adjacent one of the plurality of the electrically insulating layer structures.

10. The component carrier (100) according to claim 9,
wherein at least one pillar (107) is connected to one of the plurality of electrically conductive layer structures (104); and/or
wherein at least one pillar (107) in at least one of the plurality of electrically insulating layer structure is connected to at least one pad (105) in one of the adjacent electrically insulating layer structure through the connection structure (120); and/or
wherein the dielectric material (108) of two adjacent of the plurality of electrically insulating layer structures are intermingled one to another at a contact area.

11. The component carrier (100) according to one of the preceding claims, further comprising at least one of the following features:
a surface finishing layer (150) provided on the exposed surface of the at least one electrically vertical connection (110), in particular an external surface of the at least one pad (105) or the at least one pillar (107) of an outermost layer;
wherein the exposed surface of the at least one pad (105) or of the at least one pillar (107) flushes with a main surface of the first electrically insulating layer structure (130), in particular the main surface opposed to that where the connection structure (120) is exposed;
wherein two respective extremities of the at least one electrically vertical connection (110) of two adjacent electrically insulating layer structures are welded with an additional material;
wherein each of the electrically vertical connections (110) of the at least one of the electrically insulating layer structure are fully encapsulated by the respective dielectric material (108) except the exposed surfaces.

12. The component carrier (100) according to one of the preceding claims, wherein the component carrier (100) is configured as a bridge, in particular configured to connect at least two components one to another;
in particular
wherein the at least two components are interconnected with each other by the plurality of electrically conductive layer structures (104) connecting to the exposed pad (105) and/or the exposed pillar (107), and/or
wherein the at least two components are connected to a further component carrier (500), located on another side of the stack (102), by the plurality of electrically conductive layer structures (104) connecting to the exposed pad (105) and/or the exposed pillar (107).

13. The component carrier (100) according to one of the preceding claims, wherein the component carrier (100) comprises a soldering structure (140) on at least one main surface of one of the plurality of electrically insulating layer structures (106), which is provided on an outmost layer of the stack (102).

14. The component carrier (100) according to one of the preceding claims, wherein the component carrier (100) has a coreless structure.

15. A method of manufacturing a component carrier (100), wherein the method comprises:
forming a stack (102) having a plurality of electrically insulating layer structures (106) and a plurality of electrically conductive layer structures (104);
encapsulating at least one electrically vertical connection (110) by a dielectric material (108) of a first electrically insulating layer structure (130) of the plurality of electrically insulating layer structures (106) of the stack (102), wherein the at least one electrically vertical connection (110) comprises at least one pad (105) and at least one pillar (107) connected to each other,
wherein the at least one pad (105) is exposed at a first main surface (112) of the first electrically insulating layer structure (130) and the at least one pillar (107) is exposed at a second main surface (113) of the first electrically insulating layer structure (130);
wherein the exposed surface of the at least one pad (105) and/or the exposed surface of the at least one pillar (107) comprises a connection structure (120) configured to be connected to at least one of the plurality of electrically conductive layer structures (104), and
wherein the dielectric material (108) exposed at the respective main surface of the first electrically insulating layer structure (130) where the connection structure (120) is exposed, is in direct contact with a second electrically insulating layer structure (131) of the plurality of electrically insulating layer structures (106).
